(19)

Europäisches
Patentamt
European
Patent Office
Office européen
des brevets

(11) **EP 3 789 818 B1**

(12) **EUROPEAN PATENT SPECIFICATION**

(45) Date of publication and mention
of the grant of the patent:
**21.01.2026  Bulletin 2026/04**

(21) Application number: **18924952.7**

(22) Date of filing: **29.06.2018**

(51) International Patent Classification (IPC):
***G02F 1/133*** *(2006.01)*      ***H01R 4/64*** *(2006.01)*

(52) Cooperative Patent Classification (CPC):
**H04M 1/0274; G06F 1/182; H01Q 1/243;**
**H01Q 1/526; H04B 1/38;** H01R 4/64

(86) International application number:
**PCT/CN2018/093817**

(87) International publication number:
**WO 2020/000421 (02.01.2020 Gazette 2020/01)**

(54) **ELECTRICAL CONNECTION ASSEMBLY AND MOBILE TERMINAL**

ELEKTRISCHE VERBINDUNGSANORDNUNG UND MOBILES ENDGERÄT

ENSEMBLE DE CONNEXION ÉLECTRIQUE ET TERMINAL MOBILE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**10.03.2021  Bulletin 2021/10**

(73) Proprietor: **HUAWEI TECHNOLOGIES CO., LTD.
Shenzhen, Guangdong 518129 (CN)**

(72) Inventors:
• **JIANG, Cheng
  Shenzhen, Guangdong 518129 (CN)**
• **MENG, Yin
  Shenzhen, Guangdong 518129 (CN)**
• **YAO, Wenxing
  Shenzhen, Guangdong 518129 (CN)**

• **SUN, Gaolong
  Shenzhen, Guangdong 518129 (CN)**
• **LIU, Yang
  Shenzhen, Guangdong 518129 (CN)**

(74) Representative: **Pfenning, Meinig & Partner mbB
Patent- und Rechtsanwälte
Theresienhöhe 11a
80339 München (DE)**

(56) References cited:
WO-A1-2017/204585      CN-A- 103 197 463
CN-A- 104 135 817      CN-A- 107 221 765
CN-A- 108 235 673      CN-U- 207 529 067
US-A- 6 011 690      US-A1- 2007 230 156
US-A1- 2010 020 456      US-A1- 2010 123 846
US-A1- 2015 109 170

## Description

### TECHNICAL FIELD

This application relates to the field of electronic communications technologies, and in particular, to a mobile terminal.

### BACKGROUND

With development of the field of mobile communications technologies, a mobile terminal such as a mobile phone becomes more integrated, and an internal structure becomes more complex. Consequently, a spacing between adjacent components becomes smaller, and even installation positions may partially overlap. In this case, to reduce signal interference between adjacent electronic components, a grounding requirement for an electronic component is increasingly high.

Stainless steel or metal aluminum is usually used to support a housing of the electronic component in the mobile phone. The electronic component may be electrically connected to the housing, to implement grounding. However, because a surface of the stainless steel or the metal aluminum is easily affected by a factor such as an insulation film or a processing technology, surface contact resistance of the stainless steel or the metal aluminum is unstable. This may cause a radiated spurious emission (Radiated Spurious Emission, RSE) phenomenon. Consequently, the grounding requirement is reduced.

Prior art useful for understanding the present invention is disclosed in US 2010/020456 A1 which describes an electrostatic guiding structure for the static electricity releasing by forming an oxide layer on the metallic case. US 2007/230156 A1 suggest an electromagnetic shielding device including a cap made of conductive rubber. WO 2017/204585 A1 discloses a protection contactor comprising a contact part and an ESD protection part. US2015/109170 A1 discloses a terminal comprising a display module, a rear housing, a middle frame and an electrical connection assembly, wherein the middle frame is located between the display module and the rear housing. US6011690A relates generally to removable PC cards of the type used with personal computers, peripherals and other electronic apparatus, and particularly to improved PC card constructions enhancing the dissipation of heat produced by circuit components enclosed within the card.

### SUMMARY

The above mentioned problems are solved by the mobile terminal according to the claims. The invention is defined in the independent claims. Additional features of the invention are provided in the dependent claims. In the following, parts of the description and drawings referring to embodiments which are not covered by the claims are not presented as embodiments of the invention, but as examples useful for understanding the invention. Embodiments of this application provide an electrical connection assembly and a mobile terminal, to resolve a problem that an electrical connection point between an electronic component and a surface with an unstable resistance is in loose contact.

To achieve the foregoing objective, the following technical solutions are used in the embodiments of this application.

According to a first aspect, an electrical connection assembly is provided. The electrical connection assembly includes a first component, a second component, a conductive component, and a first insulation layer. The first component and the second component each have a conductive surface. The conductive surface of the first component is disposed opposite to the conductive surface of the second component. The conductive component is located between the first component and the second component. The first insulation layer is disposed on the conductive surface of the first component. The conductive component is in contact with the first insulation layer. The conductive component is electrically connected to the conductive surface of the second component. In this way, in the foregoing electrical connection assembly, when the first component and the second component are to be electrically connected, the conductive surface of the first component is a non-ideal conductive surface with unstable contact resistance, the first insulation layer in contact with the conductive component may be disposed on the conductive surface of the first component, so that a capacitor is formed between the conductive component and the first component having the non-ideal conductive surface. In this way, a signal of the first component having the non-ideal conductive surface may be coupled to the conductive component by using the capacitor, and then transmitted to the second component by using the conductive component. This implements coupled feeding between the first component and the second component. In this case, on one hand, the conductive component does not need to be in direct contact with the non-ideal conductive surface of the first component, so that reliability of electrical connection can be improved, and a probability that RSE exceeds a threshold can be reduced. On the other hand, in the electrical connection assembly, it is not necessary to form a conductive coating on the non-ideal conductive surface of the first component, so that a problem of higher costs of manufacturing the conductive coating can be avoided.

With reference to the first aspect, in a possible implementation, the conductive component is in contact with the conductive surface of the second component.

Optionally, the conductive component includes a first conductive sub-component and a second conductive sub-component that are electrically connected. The first conductive sub-component and the second conductive sub-component each include a first surface and a second surface. The first surface of the first conductive sub-component is in contact with the second surface of the second conductive sub-component. The first surface of the second conductive sub-component is in contact with the first insulation layer. The second surface of the first conductive sub-component is in contact with the conductive surface of the second component. In this way, in a manufacturing process, the first conductive sub-component may be assembled on the second component, and the second conductive sub-component and the first insulation layer may be packaged together and assembled on the first component. In this case, after the first component and the second component are installed together, the first surface of the first conductive sub-component is in contact with the second surface of the second conductive sub-component, so that the electrical connection assembly can be conveniently assembled with the first component and the second component.

Optionally, a contact surface between the first surface of the first conductive sub-component and the second surface of the second conductive sub-component is located within an edge of the second surface of the second conductive sub-component. In this case, an area of the second surface of the second conductive sub-component may be greater than an area of the first surface of the first conductive sub-component. In this way, the first conductive sub-component may be mainly configured to support the first component and the second component, and the second conductive sub-component is configured to increase an area of a lower substrate of a first capacitor formed by the conductive component and the first component, to increase a capacitance of the first capacitor. This effectively improves an effect of coupled feeding between the first component and the conductive component.

Optionally, the first conductive sub-component is conductive foam or a conductive adhesive. The second conductive sub-component is a metal sheet or a conductive film. The conductive foam or the conductive adhesive may provide better support for the first component and the second component. A thickness of the metal sheet or the conductive film is relatively small, so that areas of the first surface and the second surface of the second conductive sub-component are larger.

Optionally, an area of the second surface of the second conductive sub-component is 9 mm$^2$ to 100 mm$^2$. When the area of the second conductive sub-component is less than 3 mm x 3 mm, it is difficult to reach a short-circuit point in a process in which impedance of the second conductive sub-component moves clockwise from an open-circuit point O1 along a Smith circle. However, when the area of the second conductive sub-component is greater than 10 mm x 10 mm, in a process in which the impedance of the second conductive sub-component moves clockwise from the open-circuit point along the Smith circle, the impedance of the second conductive sub-component passes through the short-circuit point and enters an inductive area. This causes relatively large impedance of the second conductive sub-component.

Optionally, the first insulation layer includes an insulation adhesive and an insulation Mylar. The insulation adhesive is in contact with the conductive surface of the first component. The insulation Mylar is in contact with the conductive component. The insulation adhesive is used for bonding, and the insulation Mylar is relatively hard in texture. Therefore, in a process of installing the first component and the second component, a phenomenon that the conductive surface of the first component or the conductive surface of the second component is loosely connected to the conductive component due to penetration of the insulation Mylar under pressure can be avoided.

With reference to the first aspect, in another possible implementation, a second insulation layer is disposed on the conductive surface of the second component. In this way, when the conductive surface of the second component is a conductive surface with stable contact resistance, the second insulation layer may be disposed on the conductive surface of the second component, so that a second capacitor is formed between the conductive component and the second component, and the conductive component may be electrically connected to the second component by using a coupled feeding function of the second capacitor.

Optionally, the conductive component includes a first conductive sub-component, a second conductive sub-component and a third conductive sub-component that are electrically connected. The first conductive sub-component, the second conductive sub-component, and the third conductive sub-component each include a first surface and a second surface. The first surface of the first conductive sub-component is in contact with the second surface of the second conductive sub-component. The first surface of the second conductive sub-component is in contact with the first insulation layer. The second surface of the first conductive sub-component is in contact with the first surface of the third conductive sub-component. The second surface of the third conductive sub-component is in contact with the second insulation layer. In this way, in a manufacturing process, the second conductive sub-component and the first insulation layer may be packaged together and assembled on the first component; the third conductive sub-component and the second insulation layer may be packaged together and assembled on the second component; the first conductive sub-component may be attached to the first surface of the third conductive sub-component in an adhesive bonding manner; and then the first component and the second component are installed together, so that the first surface of the first conductive sub-component is in contact with the second surface of the second conductive sub-component. In this way, the electrical connection assembly can be conveniently assembled with the first component and the second component.

Optionally, a contact surface between the first surface of the first conductive sub-component and the second surface of the second conductive sub-component is located within an edge of the second surface of the second conductive sub-component. In this case, an area of the second surface of the second conductive sub-component may be greater than an area of the first surface of the first conductive sub-component. In this way, the first conductive sub-component may be mainly configured to support the first component and the second component, and the second conductive sub-component is configured to increase the area of the lower substrate of the first capacitor formed by the conductive component and the first component, to increase the capacitance of the first capacitor. This effectively improves the effect of the coupled feeding between the first component and the conductive component.

In addition, a contact surface between the second surface of the first conductive sub-component and the first surface of the third conductive sub-component is located within an edge of the first surface of the third conductive sub-component. In this case, an area of the first surface of the third conductive sub-component may be greater than an area of the second surface of the first conductive sub-component. In this way, the first conductive sub-component may be mainly configured to support the first component and the second component, and the third conductive sub-component is configured to increase an area of an upper substrate of the second capacitor formed by the conductive component and the second component, to increase a capacitance of the second capacitor. This effectively improves the effect of coupled feeding between the second component and the conductive component.

Optionally, the first conductive sub-component is conductive foam or a conductive adhesive. The second conductive sub-component and the third conductive sub-component are metal sheets or conductive films. The conductive foam or the conductive adhesive may provide better support for the first component and the second component. Thicknesses of the metal sheets or the conductive films are relatively small, so that areas of the first surface and the second surface of the second conductive sub-component or the third conductive sub-component are larger.

Optionally, the area of the second surface of the second conductive sub-component is 9 mm$^2$ to 100 mm$^2$. The area of the first surface of the third conductive sub-component is 9 mm2 to 100 mm2. The area of the second surface of the second conductive sub-component and the area of the first surface of the third conductive sub-component have a same technical effect as that of the area of the second surface of the second conductive sub-component in the foregoing embodiment. Details are not described herein again.

Optionally, the first insulation layer includes a first insulation adhesive and a first insulation Mylar. The first insulation adhesive is in contact with the conductive surface of the first component. The first insulation Mylar is in contact with the conductive component. In addition, the second insulation layer includes a second insulation adhesive and a second insulation Mylar. The second insulation adhesive is in contact with the conductive surface of the second component. The second insulation Mylar is in contact with the conductive component. The first insulation adhesive and the second insulation adhesive have a same technical effect as that of the insulation adhesive provided in the foregoing embodiment, and details are not described herein again. The first insulation Mylar and the second insulation Mylar have a same technical effect as that of the insulation Mylar provided in the foregoing embodiment, and details are not described herein again.

Alternatively, the second insulation layer includes an insulation film and the second insulation adhesive. The insulation film covers the conductive surface of the second component. The second insulation adhesive is located between the insulation film and the conductive component, and the second insulation adhesive is in contact with the insulation film and the conductive component. In this way, when the insulation film is disposed, the second insulation Mylar does not need to be disposed. The insulation film layer may be an oxidized layer formed by using an anodic oxidation process, or an insulated film layer formed by using a spray coating process.

With reference to the first aspect, in another possible implementation, the conductive component includes a support part and a conductive body. At least three surfaces of the support part are covered with the conductive body. The at least three surfaces of the support part include a surface close to the first component and a surface close to the second component. In this case, before the first component and the second component are assembled, the conductive body may be in close contact with the support part. Therefore, when the first component and the second component are assembled, no relatively large pressure needs to be applied to the support part. Therefore, the foregoing solution is applicable to a relatively pressure-sensitive component, for example, a display screen that is installed with a metal frame, or a camera.

Optionally, the first insulation layer includes a first insulation adhesive and a first insulation Mylar. The first insulation adhesive is in contact with the conductive surface of the first component. The first insulation Mylar is in contact with the conductive component.

In addition, when a second insulation layer is disposed on the conductive surface of the second component, the second insulation layer includes a second insulation adhesive and a second insulation Mylar. The second insulation adhesive is in contact with the conductive surface of the second component. The second insulation Mylar is in contact with the conductive component. The first insulation adhesive and the second insulation adhesive have a same technical effect as that of the insulation adhesive provided in the foregoing embodiment, and details are not described herein again. The first insulation Mylar and the second insulation Mylar have a same technical effect as that of the insulation Mylar provided in the foregoing embodiment, and details are not described herein again.

Alternatively, the second insulation layer includes an insulation film and the second insulation adhesive. The insulation film covers the conductive surface of the second component. The second insulation adhesive is located between the insulation film and the conductive component, and the second insulation adhesive is in contact with the insulation film and the conductive component. The insulation film has a same technical effect as that of the insulation film provided in the foregoing embodiment, and details are not described herein again.

Alternatively, when the second insulation layer includes the insulation film and the second insulation adhesive, the conductive component further includes a conductive extension part connected to the conductive body. A vertical projection of the conductive body on the second component does not overlap a vertical projection of the conductive extension part on the second component. In addition, at least the conductive extension part is in contact with the second insulation adhesive. In this way, based on an appropriate reduction of a volume of the support part, the conductive extension part being disposed on the conductive component may increase an area of an upper substrate of a second capacitor formed by the conductive component and the second component. This improves the effect of coupled feeding.

Optionally, when the volume of the support part is reduced, to avoid a decrease of a capacitance of the second capacitor formed by the conductive component and the second component, the conductive component further includes a fourth conductive sub-component. The fourth conductive sub-component includes a first surface and a second surface. The first surface of the fourth conductive sub-component is in contact with the first insulation Mylar. The second surface of the fourth conductive sub-component is in contact with the conductive body. In this case, the fourth conductive sub-component may be a copper foil. An area of a lower surface of the copper foil may be greater than an area of an upper surface of the support part, so that the capacitance of the second capacitor does not decrease when the volume of the support part is reduced.

With reference to the first aspect, in another possible implementation, the conductive component includes a support part and a conductive body. The first insulation layer includes an insulation adhesive and an insulation Mylar. At least three surfaces of the support part are sequentially covered with the conductive body and the insulation Mylar. The at least three surfaces of the support part include a surface close to the first component and a surface close to the second component. In this way, the support part, the conductive body, and the insulation Mylar may be packaged together, and then assembled on the first component by using the insulation adhesive. Next, after the first component and the second component are installed together, a lower surface of the insulation Mylar is in contact with the conductive surface of the second component, so that the electrical connection assembly can be conveniently assembled with the first component and the second component. In addition, because the conductive body may be in close contact with the support part, when the first component and the second component are assembled, no relatively large pressure needs to be applied to the support part.

Optionally, the support part is foam. The conductive body is a metal sheet or a conductive film. A technical effect of the foam and the metal sheet or the conductive film is the same as that described above, and details are not described herein again.

Optionally, an area of the surface, close to the first component or the second component, of the support part is 9 mm$^2$ to 100 mm$^2$. The area of the surface, close to the first component or the second component, of the support part has a same technical effect as that of the area of the second surface of the second conductive sub-component in the foregoing embodiment. Details are not described herein again.

Optionally, a thickness of the first insulation layer is 0.01 mm to 0.05 mm. When the thickness of the first insulation layer is less than 0.01 mm, a requirement on manufacturing precision is relatively high, which is not conducive to reducing a production cost. When the thickness of the first insulation layer is greater than 0.05 mm, the thickness is not conducive to increasing a capacitance C of a planar capacitor.

Optionally, the conductive component and the first component form a first capacitor, so that the conductive component and the first component can implement a non-contact electrical connection between the conductive component and the first component by using a coupled feeding function of the first capacitor. In addition, the conductive component and the second component form the second capacitor, so that the conductive component and the second component can implement a non-contact electrical connection between the conductive component and the second component by using a coupled feeding function of the second capacitor.

According to a second aspect, a mobile terminal is provided, including any one of the foregoing electrical connection assemblies. The mobile terminal has a same technical effect as that of the electrical connection assembly provided in the foregoing embodiments. Details are not described herein again.

## BRIEF DESCRIPTION OF DRAWINGS

FIG. 1 is a schematic structural diagram of an electrical connection assembly according to some embodiments of this application;

FIG. 2 is a schematic structural diagram of a mobile terminal according to some embodiments of this application;

FIG. 3 is a schematic structural diagram of another mobile terminal according to some embodiments of this application;

FIG. 4 is an equivalent circuit diagram corresponding to a structure shown in FIG. 1;

FIG. 5 is a schematic structural diagram of another electrical connection assembly according to some embodiments of this application;

FIG. 6 is an equivalent circuit diagram corresponding to a structure shown in FIG. 5;

FIG. 7 is a schematic structural diagram of another electrical connection assembly according to some embodiments of this application;

FIG. 8 is a schematic structural diagram of another electrical connection assembly according to some embodiments of this application;

FIG. 9a is a schematic structural diagram of another electrical connection assembly according to some embodiments of this application;

FIG. 9b is a schematic structural diagram of another electrical connection assembly according to some embodiments of this application;

FIG. 10 is an equivalent circuit diagram corresponding to the structure shown in FIG. 9a;

FIG. 11 is a schematic diagram of a division principle of a second conductive sub-component shown in FIG. 9a;

FIG. 12 is an equivalent circuit diagram of a structure shown in FIG. 11;

FIG. 13 is a Smith chart according to some embodiments of this application;

FIG. 14 is a Smith chart according to some other embodiments of this application;

FIG. 15 is a schematic structural diagram of a mobile terminal according to some embodiments of this application;

FIG. 16 is a diagram of a test result of performing an antenna anti-interference test by using a structure shown in FIG. 15;

FIG. 17 is a schematic structural diagram of a mobile terminal according to some embodiments of this application;

FIG. 18a is a schematic structural diagram of an electrical connection assembly according to some embodiments of this application;

FIG. 18b is a schematic structural diagram of another electrical connection assembly according to some embodiments of this application;

FIG. 19 is a schematic structural diagram of an electrical connection assembly according to some embodiments of this application;

FIG. 20 is a schematic structural diagram of another electrical connection assembly according to some embodiments of this application;

FIG. 21a is a schematic structural diagram of another electrical connection assembly according to some embodiments of this application;

FIG. 21b is a schematic structural diagram of another electrical connection assembly according to some embodiments of this application;

FIG. 21c is a schematic structural diagram of another electrical connection assembly according to some embodiments of this application;

FIG. 21d is a schematic structural diagram of another electrical connection assembly according to some embodiments of this application;

FIG. 22 is a schematic structural diagram of another electrical connection assembly according to some embodiments of this application;

FIG. 23 is a schematic structural diagram of another electrical connection assembly according to some embodiments of this application;

FIG. 24 is a schematic structural diagram of another electrical connection assembly according to some embodiments of this application; and

FIG. 25 is another Smith chart according to some embodiments of this application.

Reference numerals:

01: electrical connection assembly; 02: mobile terminal; 10: first component; 11: second component; 12: gold-plated spot welding spring; 110: display module; 1101: display screen; 1102: touch panel; 1103: metal frame; 111: middle frame; 1110: frame; 1111: bearing plate; 112: rear housing; 113: metal shielding case; 114: antenna; 20: second component; 30: conductive component; 301: first conductive sub-component; 302: second conductive sub-component; 303: second conductive sub-component; 304: fourth conductive sub-component; 311: support part; 312: conductive body; 313: conductive extension part; 40: first insulation layer; 401: insulation adhesive; 402: insulation Mylar; 411: first insulation adhesive; 412: first insulation Mylar; 41: second insulation layer; 421: second insulation adhesive; 422: second insulation Mylar; and 403: insulation film.

## DESCRIPTION OF EMBODIMENTS

The terms "first" and "second" mentioned below are merely intended for description, and shall not be understood as an indication or implication of relative importance or implicit indication of a quantity of indicated technical features. Therefore, a feature limited by "first" or "second" may explicitly or implicitly include one or more features.

In addition, in this application, terms of direction such as "upper", "lower", "left", and "right" are defined relative to an illustrated placement position of a component in an accompanying drawing. It should be understood that these directional terms are relative concepts and are used to describe and clarify relativity, and may be changed accordingly as a placement position of the component in the accompanying drawing changes.

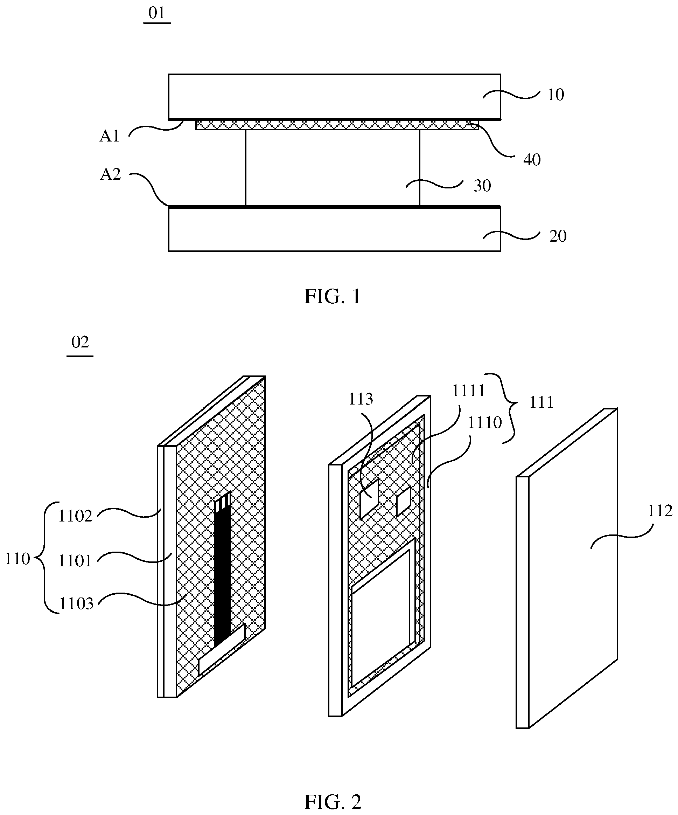

Some embodiments of this application provide an electrical connection assembly 01. As shown in FIG. 1, the electrical connection assembly 01 includes a first component 10 and a second component 20. There may be an installation tolerance between the first component 10 and the second component 20. The first component 10 and the second component 20 may be installed together in a detachable connection manner, for example, a threaded connection manner, a buckle connection manner, or a bonding manner.

Some embodiments of this application further provide a mobile terminal 02 shown in FIG. 2. The electrical connection assembly 01 may be applied to the mobile terminal 02. The mobile terminal 02 may include a mobile phone, a tablet computer, a personal digital assistant (Personal Digital Assistant, PDA), a vehicle-mounted computer, and the like. A specific form of the mobile terminal is not particularly limited in the embodiments of this application.

For example, the mobile terminal 02 is a mobile phone. As shown in FIG. 2, the mobile phone may include a display module 110, a middle frame 111, a rear housing 112, and the like.

The display module 110 includes a display screen 1101 and a touch panel 1102 disposed on a light-emitting side of the display screen 1101.

It should be noted that the display screen 1101 may be a liquid crystal display (Liquid Crystal Display, LCD) or an organic light-emitting diode (Organic Light Emitting Diode, OLED) display. This is not limited in this application.

In addition, the touch panel 1102 may include a cover made of glass or a transparent resin material, and a touch electrode pattern made on the cover and close to the display screen 1011.

The middle frame 111 is located between the display module 110 and the rear housing 112. The middle frame 111 includes a frame 1110 and a bearing plate 1111 surrounded by the frame. The display module 110 is installed on a side of the bearing plate 1111, and internal components such as a battery, a main board, a camera (Camera), and an antenna are installed on another side. The frame 1110 and the bearing plate 1111 that are configured to form the middle frame 111 may be an integrated structure.

The rear housing 112 is installed on the middle frame 111, and the rear housing 112 can protect the internal components.

In this case, when the mobile terminal 02 includes the electrical connection assembly 01, the first component 10 and the second component 20 of the electrical connection assembly 01 may be the display module 110 and the middle frame 111 respectively. Alternatively, the first component 10 and the second component 20 of the electrical connection assembly 01 may be the middle frame 111 and the rear housing 112 respectively.

The first component 10 and the second component 10 each have a conductive surface. As shown in FIG. 1, a conductive surface A1 of the first component 10 is disposed opposite to a conductive surface A2 of the second component 20.

In some embodiments of this application, when the first component 10 and the second component 20 may be the display module 110 and the middle frame 111 respectively, as shown in FIG. 2, the display module 110 may further include a metal frame 1103 installed on a non-light-emitting side of the display screen 1101. A side, away from the display screen 1101, of the metal frame 1103 may be attached to the middle frame 111 by using an adhesive layer, to install the display module 110 on the middle frame 111.

It should be noted that the non-light-emitting side of the display screen 1101 is a surface opposite to the light-emitting side (close to the touch panel 1102) of the display screen 1101.

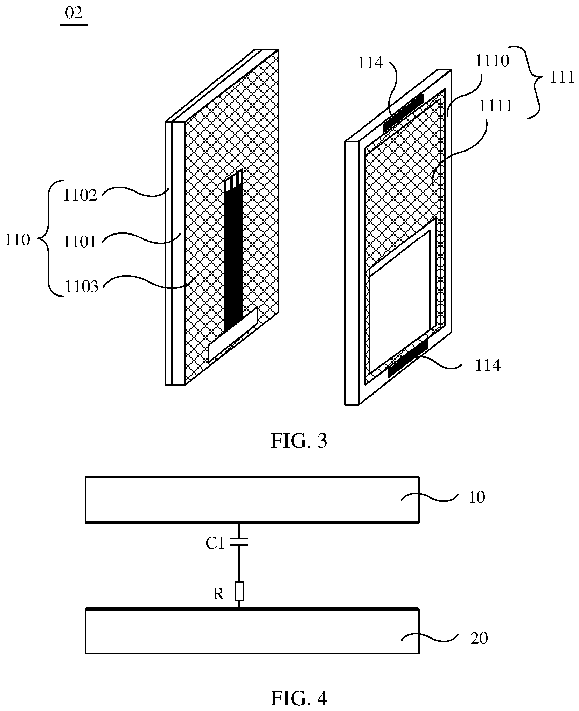

As shown in FIG. 3, an antenna 114 is usually installed on a surface, close to the rear housing 112, of the middle frame 111 of the mobile phone. The metal frame 1103 may prevent the display screen 1101 from absorbing energy radiated by the antenna 114. The antenna 114 may be disposed on an upper side or a lower side of the frame 1110 of the middle frame 111.

Based on this, the conductive surface A1 of the display module 110 of the first component 10 is a surface, close to the middle frame 111, of the metal frame 1103.

In addition, a metal conductive surface is disposed on the middle frame 111 of the second component 20 and is close to the metal frame 1103. The metal conductive surface is used as the conductive surface A2 of the second component 20.

For example, when a material constituting the middle frame 111 is a conductive material, for example, stainless steel or aluminum, a surface, close to the metal frame 1103, of the bearing plate 1111 in the middle frame 111 may be the conductive surface A2 of the second component 20.

Alternatively, when the material constituting the middle frame 111 includes aluminum or aluminum alloy, to improve a conductivity of the conductive surface A2 of the second component 20, an aluminum laser engraving surface may be formed on the metal surface, close to the metal frame 1103, of the bearing plate 1111 in the middle frame 111 by using a laser engraving process. The aluminum laser engraving surface is used as the conductive surface A2 of the second component 20.

It should be noted that the foregoing is described by using an example in which the aluminum laser engraving surface is used as the conductive surface A2 of the second component 20. In addition, in some other embodiments of this application, when the second component 20 has a conductor material with relatively stable chemical performance and a relatively high conductivity, for example, a metal coating constituted by gold, nickel, copper, and the like, the metal coating may also be used as the conductive surface A2 of the second component 20. Compared with a manufacturing process of the metal coating, a manufacturing process of the aluminum laser engraving surface has a lower cost. For ease of description, the following uses the example in which the aluminum laser engraving surface is the conductive surface A2 of the second component 20 for description.

In some other embodiments of this application, as shown in FIG. 2, a metal shielding case 113 is disposed on the middle frame 111 and is close to the rear housing 112. The metal shielding case 113 is configured to cover a chip installed on the main board, to reduce signal interference generated between chips. The metal shielding case 113 may be made of stainless steel.

Based on this, when the first component 10 and the second component 20 may be the middle frame 111 and the rear housing 112 respectively, the conductive surface A1 of the middle frame 111 of the first component 10 is a surface, close to the rear housing 112, of the metal shielding case 113.

In addition, a metal conductive surface is disposed on the rear housing 112 of the second component 20 and is close to the metal shielding case 113. The metal conductive surface is used as the conductive surface A2 of the second component 20.

For example, when a material constituting the rear housing 112 is a conductive material, the surface, close to the metal shielding case 113, of the rear housing 112 may be the conductive surface A2 of the second component 20.

Alternatively, when the material constituting the rear housing 112 includes aluminum or aluminum alloy, to improve the conductivity of the conductive surface A2 of the second component 20, an aluminum laser engraving surface may be formed on a metal surface, close to the middle frame 111 and opposite to the metal shielding case 113, of the rear housing 112 by using a laser engraving process. The aluminum laser engraving surface is used as the conductive surface A2 of the second component 20.

In addition, as shown in FIG. 1, the electrical connection assembly 01 further includes a conductive component 30 and a first insulation layer 40.

The conductive component 30 is located between the first component 10 and the second component 20. The first insulation layer 40 is disposed on the conductive surface A1 of the first component 10.

The conductive component 30 is in contact with the first insulation layer 40. The conductive component 30 and the first component 10 may form a first capacitor C1 shown in FIG. 4. An upper substrate of the first capacitor C1 is the first component 10, and a lower substrate is the conductive component 30. In this case, with a coupled feeding function of the first capacitor C1, electrical connection may be implemented between the conductive component 30 and the first component 10 that are not in contact with each other.

In addition, the conductive component 30 is electrically connected to the conductive surface A2 of the second component 20.

In some embodiments of this application, as shown in FIG. 1, a manner in which the conductive component 30 is electrically connected to the conductive surface A2 of the second component 20 may be that the conductive component 30 is in contact with the conductive surface A2 of the second component 20. As shown in FIG. 4, contact resistance R may be formed on a contact surface between the conductive component 30 and the conductive surface A2 of the second component 20. In this case, the conductivity of the conductive surface A2 of the second component 20 may be greater than a conductivity of the conductive surface A1 of the first component 10. In this case, the conductive surface A2 of the second component 20 is a good conductor, and a resistance value of the contact resistance R is relatively small and may be less than 0.25 $\Omega$.

For example, the first component 10 and the second component 20 are the display module 110 and the middle frame 111 respectively.

The metal frame 1103 installed on the non-light-emitting side of the display screen 1101 in the display module 110 is made of stainless steel. The aluminum laser engraving surface is on the surface, close to the metal frame 1103, of the bearing plate 1111 in the middle frame 111.

In this case, to improve a grounding environment around the antenna 114, the metal frame 1103 on the back of the display screen 1101 may be electrically connected to the aluminum laser engraving surface on the middle frame 111, to implement grounding of the metal frame 1103, thereby reducing interference to the antenna 114.

Based on this, because an insulation film formed after oxidation of the stainless steel is relatively thick, a conductivity of the surface, close to the middle frame 111 and used as the conductive surface A1 of the first component 10, of the metal frame 1103 is relatively low. In addition, the aluminum laser engraving surface used as the conductive surface A2 of the second component 20 has a good conductivity. Therefore, the conductivity of the aluminum laser engraving surface is relatively high.

In this case, when the metal frame 1103 on the back of the display screen 1101 is electrically connected to the aluminum laser engraving surface on the middle frame 111, the electrical connection assembly 01 shown in FIG. 1 may be used. To be specific, the first insulation layer 40 is disposed on the metal frame 1103 on the back of the display screen 1101; the conductive component 30 is in contact with the first insulation layer 40; and a surface, away from the first insulation layer 40, of the conductive component 30 is in contact with the aluminum laser engraving surface on the middle frame 111.

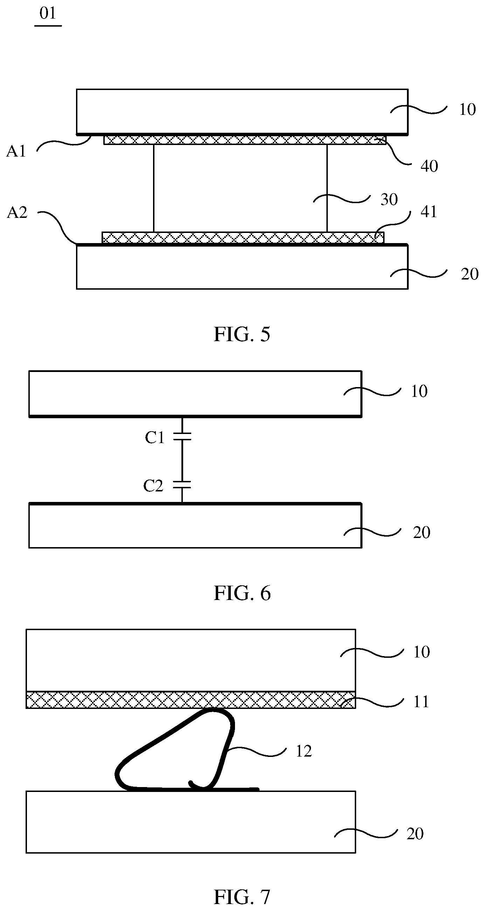

Alternatively, as shown in FIG. 5, a manner in which the conductive component 30 is electrically connected to the conductive surface A2 of the second component 20 may be that a second insulation layer 41 is disposed on the conductive surface A2 of the second component 20. In this case, the conductive component 30 and the second component 20 may form a second capacitor C2 shown in FIG. 6. An upper substrate of the second capacitor C2 is the conductive component 30, and a lower substrate is the second component 20.

For example, the first component 10 and the second component 20 are the display module 110 and the middle frame 111 respectively. The metal frame 1103 on the back of the display screen 1101 and the middle frame 111 are made of stainless steel.

When the metal frame 1103 on the back of the display screen 1101 is electrically connected to the middle frame 111, to implement grounding of the metal frame 1103, because the insulation film formed after oxidation of the stainless steel is relatively thick, a contact resistance on the conductive surface is unstable. Therefore, the surface, close to the metal frame 1103 and used as the conductive surface A2 of the second component 20, of the middle frame 111, and the surface, close to the middle frame 111 and used as the conductive surface A1 of the first component 10, of the metal frame 1103 are non-ideal conductive surfaces with unstable contact resistance and relatively low conductivities.

In this case, when the metal frame 1103 on the back of the display screen 1101 is electrically connected to the middle frame 111, the electrical connection assembly 01 shown in FIG. 5 may be used. To be specific, the first insulation layer 40 is disposed on the metal frame 1103 on the back of the display screen 1101; the second insulation layer 41 is disposed on the middle frame 111 and is close to the metal frame 1103; an upper surface of the conductive component 30 is in contact with a lower surface of the first insulation layer 40; and a lower surface of the conductive component 30 is in contact with an upper surface of the second insulation layer 41.

It may be learned from the foregoing description that, in the electrical connection assembly 01, when the first component 10 or the second component 20 are to be electrically connected, a conductive surface of either component, for example, the conductive surface of the first component 10 is a non-ideal conductive surface with unstable contact resistance, the first insulation layer 40 in contact with the conductive component 30 may be disposed on the conductive surface of the first component 10. In this way, the first capacitor C1 is formed between the conductive component 30 and the first component 10 having the non-ideal conductive surface. In this way, a signal of the first component 10 having the non-ideal conductive surface may be coupled to the conductive component 30 by using the first capacitor C1, and then transmitted to the second component 20 by using the conductive component 30.

Based on this, in a solution shown in FIG. 7, a lower surface of the first component 10 with the unstable contact resistance needs to be coated with a good conductive coating 11 (for example, a nickel coating), and the first component 10 and the second component 20 are electrically connected by using a gold-plated spot welding spring 12. Compared with the solution shown in FIG. 7, in a solution shown in FIG. 1 or FIG. 5 provided in the embodiments of this application, it is not necessary to coat, on the lower surface of the first component 10 with the unstable contact resistance, the good conductive coating 11, and a spot welding process is not required. The second component 20 is electrically connected to the first component 10 by using the gold-plated spot welding spring 12. Therefore, costs can be reduced.

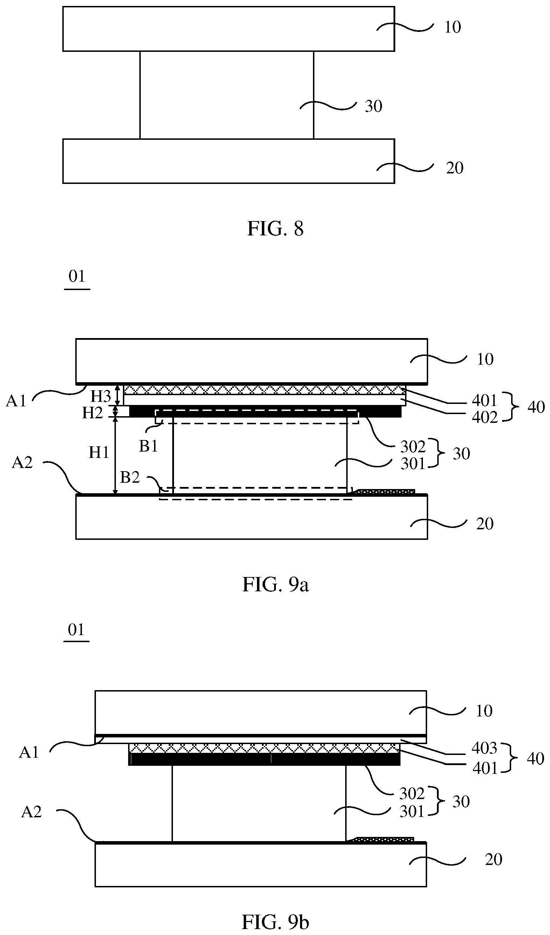

In addition, in a solution shown in FIG. 8, the upper surface of the conductive component 30 is in contact with the lower surface of the first component 10, and the lower surface of the conductive component 30 is in contact with an upper surface of the second component 20. Compared with the solution shown in FIG. 8, the solution shown in FIG. 1 or FIG. 5 provided in the embodiments of this application can, when the contact resistance of the lower surface of the first component 10 is unstable, reduce a probability that RSE exceeds a threshold caused by low electrical connection reliability and a poor grounding effect around the antenna 114 brought by direct contact between the conductive component 30 and the lower surface of the first component 10.

A structure of the conductive component 30 is described in detail below.

Example 1

In this example, as shown in FIG. 9a, an example in which the conductive surface A1 of the first component 10 is a conductive surface with unstable contact resistance, the first insulation layer 40 is disposed on the conductive surface A1 of the first component 10, and the conductive component 30 is in contact with the conductive surface A2 of the second component 20 is used for description.

Based on this, as shown in FIG. 9a, the conductive component 30 includes a first conductive sub-component 301 and a second conductive sub-component 302 that are electrically connected.

The first conductive sub-component 301 and the second conductive sub-component 302 each include a first surface and a second surface. The first surface and the second surface may be disposed opposite to each other. The first surface is an upper surface, and the second surface is a lower surface. For example, the first surface of the first conductive sub-component 301 is an upper surface of the first conductive sub-component 301 (namely, a surface close to the first component 10), and the second surface of the first conductive sub-component 301 is a lower surface of the first conductive sub-component 301 (namely, a surface close to the second component 20). The first surface and the second surface of the second conductive sub-component 302 may be disposed in a similar manner.

Based on this, as shown in FIG. 9a, the first surface of the first conductive sub-component 301 is in contact with the second surface of the second conductive sub-component 302. The first surface of the second conductive sub-component 302 is in contact with the first insulation layer 40. The second surface of the first conductive sub-component 301 is in contact with the conductive surface A2 of the second component 20.

In some embodiments of this application, the first conductive sub-component 301 may be conductive foam or a conductive adhesive. The first conductive sub-component 301 conducts electricity, and may further be configured to support the first component 10 and the second component 20 that are located on two sides of the first conductive sub-component 301. In addition, the first conductive sub-component 301 may further have a function of absorbing an installation tolerance between the first component 10 and the second component 20. Therefore, after the first component 10 and the second component 20 are installed, the upper surface of the first conductive sub-component 301 is in contact with the lower surface of the second conductive sub-component 302.

The conductive foam may be formed by wrapping a conductive fabric on a surface of common non-conductive foam. Alternatively, a conductive coating is made on the surface of the common non-conductive foam, to form the conductive foam.

In addition, the second conductive sub-component 302 may be a metal sheet or a conductive film. The metal sheet may be a copper foil. The conductive film may be a conductive fabric. The conductive fabric includes a flexible substrate and a metal coating disposed on the flexible substrate. The metal coating may be at least one of a gold coating, a nickel coating, or a copper coating. This is not limited in this application. For ease of description, the following embodiments are described based on the first conductive sub-component 301 being the conductive foam and the second conductive sub-component 302 being the copper foil.

In this case, a thickness H2 of the second conductive sub-component 302 may be less than a thickness H1 of the first conductive sub-component 301. A direction of the thicknesses is perpendicular to the conductive surface A1 of the first component 10.

Based on this, as shown in FIG. 9a, a manner of disposing the first conductive sub-component 301 and the second conductive sub-component 302 of the conductive component 30 may be that a contact surface between the first surface of the first conductive sub-component 301 and the second surface of the second conductive sub-component 302 is located within an edge of the second surface of the second conductive sub-component 302.

In this case, the copper foil used as the second conductive sub-component 302 is tiled on a surface, close to the second conductive sub-component 302, of the first insulation layer 40, and the conductive foam used as the first conductive sub-component 301 is in contact with only a part of the copper foil. A part, not in contact with the conductive foam, of the copper foil extends out of an area in which the conductive foam is located. In this way, a capacitance of a first capacitor formed by the conductive component 30 and the first component 10 may be increased by using the second conductive component 302. This effectively improves an effect of coupled feeding between the first component 10 and the conductive component 30.

In addition, as shown in FIG. 9a, the first insulation layer 40 includes an insulation adhesive 401. The insulation adhesive 401 has an insulation and adhesive effect.

Based on this, in a process of installing the first component 10 and the second component 20, to avoid a phenomenon that contact resistance of the conductive surface of the first component 10 or the second component 20 is unstable due to a loose connection, caused by penetration of the first insulation layer 40 due to pressure applied to the first component 10 or the second component 20, between the conductive surface of the first component 10 or the second component 20 and the conductive component 30, the first insulation layer 40 may further include an insulation Mylar 402.

The insulation adhesive 401 is in contact with the conductive surface A1 of the first component 10. The insulation Mylar 402 is in contact with the conductive component 30. As shown in FIG. 9a, when the conductive component 30 includes the first conductive sub-component 301 and the second conductive sub-component 302, the insulation Mylar 402 is in contact with the second conductive sub-component 302.

A material constituting the insulation Mylar 402 may be polyethylene terephthalate plastic (Polyethylene Terephthalate, PET). The insulation Mylar 402 is relatively hard in texture. Therefore, in the process of installing the first component 10 and the second component 20, a phenomenon that the conductive surface of the first component 10 or the conductive surface of the second component 20 is loosely connected to the conductive component 30 due to penetration of the insulation Mylar 402 under pressure can be avoided.

It should be noted that, when the first insulation layer 40 includes the insulation adhesive 401 and the insulation Mylar 402, and the conductive component 30 includes the first conductive sub-component 301 and the second conductive sub-component 302, the insulation adhesive 401 and the insulation Mylar 402 may be first attached together in a manufacturing process. Then, the second conductive sub-component 302, namely, the copper foil, is disposed on a surface, away from the insulation adhesive 401, of the insulation Mylar 402 by using an adhesive or a hot melt process. In this case, the first insulation layer 40 is packaged with the second conductive sub-component 302. Next, the packaged components are assembled on the first component 10, so that a surface, away from the insulation Mylar 402, of the insulation adhesive 401 is attached to the conductive surface A1 of the first component 10.

To avoid contact between the second conductive sub-component 302 and the conductive surface A1 of the first component 10, a contact surface between the second conductive sub-component 302 and the insulation Mylar 402 is located within an edge of a lower surface of the insulation Mylar 402.

In addition, the first conductive sub-component 301 is disposed on the conductive surface A2 of the second component 20 by using an adhesive.

Next, the first component 10 and the second component 20 are installed together, so that the first surface of the first conductive sub-component 301 is in contact with the second surface of the second conductive sub-component 302.

In addition, when a surface of a component on which the insulation adhesive 401 is formed, namely, the conductive surface A1 of the first component 10 is processed by using a process such as anodizing to form an insulation film 403 shown in FIG. 9b, the insulation Mylar 402 may not be disposed. In this case, the first insulation layer 40 includes an insulation film 403 and the insulation adhesive 401. The insulation film 403 covers the conductive surface A1 of the first component 10. The insulation adhesive 401 is located between the insulation film 403 and the conductive component 30, and in contact with the insulation film 403 and the conductive component 30. In this case, the copper foil, used as the second conductive sub-component 302 of the conductive component 30, may be attached to a lower surface of the insulation film 403 by using the insulation adhesive 401.

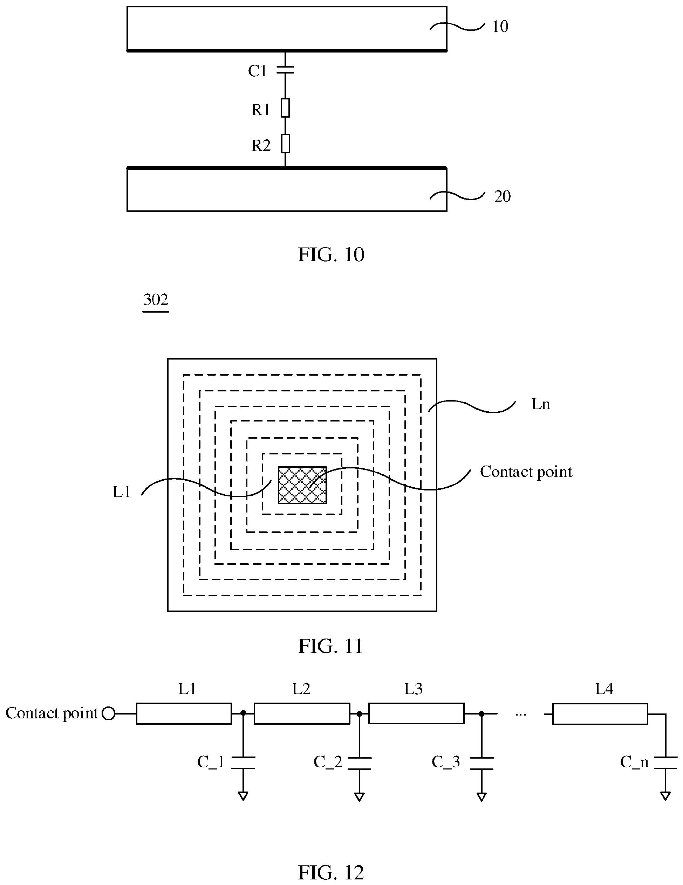

It may be learned from the foregoing description that, in FIG. 9a, the first insulation layer 40 is disposed on the conductive surface A1 of the first component 10, and the copper foil (namely, the second conductive sub-component 302) of the conductive component 30 is in contact with the first insulation layer 40. In this case, the first component 10 and the copper foil form a first capacitor C1 shown in FIG. 10. A signal of the first component 10 may be coupled to the copper foil by using the first capacitor C1.

In addition, the conductive surface A2 of the second component 20 is a conductive surface with stable contact resistance. Therefore, only a few adhesives are required between the conductive foam (namely, the first conductive sub-component 301) of the conductive component 30 and the second component 20 provided that the conductive foam is fastened on the second component 20. Most of the conductive foam is in direct contact with the conductive surface A2 of the second component 20. In this case, as shown in FIG. 9a, an ideal contact resistance R1 with a small resistance value (for example, about $0.2\,\Omega$) in FIG. 10 is formed at a position B1 at which the first surface of the conductive foam is in contact with the second surface of the copper foil; and an ideal contact resistance R2 with a small resistance value (for example, about $0.2\,\Omega$) in FIG. 10 is formed at a position B2 at which the second surface of the conductive foam is in contact with the conductive surface A2 of the second component 20. In this case, a signal of the copper foil may be directly transmitted to the second component 20 by using the conductive foam.

It may be learned from the foregoing disposing manner that a capacitor configured to implement signal transmission in a capacitive coupling manner is a planar capacitor. A capacitance C of the planar capacitor meets the following formula:

$$C = \varepsilon \times \varepsilon_0 \times S/d \quad (1)$$

In the formula (1), C is the capacitance of the planar capacitor; $\varepsilon$ is a relative dielectric constant; $\varepsilon 0$ is vacuum dielectric constant; S is an area of a planar electrode, namely, an area of the conductive surface A1 of the first component 10, the copper foil, or the conductive surface A2 of the second component 20; and d is a thickness of a medium in the capacitor, namely, a thickness H3 of the first insulation layer 40 (as shown in FIG. 9a).

It should be noted that when the electrical connection assembly 01 is applied to the mobile terminal 02, a signal transmitted from the first component 10 to the second component 20 is usually an intermediate frequency signal or a high frequency signal, for example, a signal with a frequency in a range of 700 MHZ to 2.7 GHZ. For the high frequency signal, when signal transmission is implemented in the capacitive coupling manner, a larger capacitance of the capacitor indicates a better signal transmission effect.

It may be learned from the formula (1) that the capacitance C is inversely proportional to the thickness H3 of the first insulation layer 40. Therefore, a smaller thickness H3 of the first insulation layer 40 indicates a larger capacitance C. Therefore, to increase the capacitance C, in some embodiments of this application, the thickness H3 of the first insulation layer 40 may be 0.01 mm to 0.05 mm. When the thickness H3 of the first insulation layer 40 is less than 0.01 mm, a requirement on manufacturing precision is relatively high, which is not conducive to reducing a production cost. When the thickness H3 of the first insulation layer 40 is greater than 0.05 mm, the thickness is not conducive to increasing the capacitance C. Optionally, the thickness H3 of the first insulation layer 40 may be 0.01 mm, 0.015 mm, 0.02 mm, or 0.04 mm. For example, when the first insulation layer 40 includes the insulation adhesive 401 and the insulation Mylar 402, in some embodiments of this application, a thickness of the insulation adhesive 401 may be 0.01 mm, and a thickness of the insulation Mylar 402 may be 0.01 mm.

In addition, the capacitance C is proportional to the area S of upper and lower electrodes of the capacitor. An area of the conductive surface A1 of the first component 10 or the conductive surface A2 of the second component 20 is usually greater than an area of the copper foil. Therefore, a larger area of a surface, parallel to the conductive surface, of the copper foil indicates a larger capacitance C of the capacitor.

However, in a process of transmitting the intermediate and high frequency signals by using the capacitive coupling, if the area of the copper foil is increased blindly when an installation size is met, inductive impedance is increased. This reduces signal transmission efficiency.

For example, the structure shown in FIG. 9a is used as an example, the first capacitor C1 shown in FIG. 10 formed in the electrical connection assembly 01 may couple the intermediate and high frequency signals from the first component 10 to the second component 20 in the capacitive coupling manner. As shown in FIG. 11, a lower substrate copper foil (namely, the second conductive sub-component 302) of the first capacitor C1 may be considered as a coil wound from outside to inside, and the coil is finally wound to a contact point located in the center. The contact point is an area in which the copper foil is in contact with the conductive foam (namely, the first conductive sub-component 301).

In FIG. 11, a plurality of distributed capacitors (C_1, C_2, C_3, ..., C_n) are respectively formed between the conductive surface A1 of the first component 10 and a plurality of coils (L1, L2, L3, ..., Ln). Each of the coils is obtained by dividing two adjacent dashed lines. An equivalent circuit obtained after the copper foil is divided into coils is shown in FIG. 12. It may be seen that the plurality of distributed capacitors (C_1, C_2, C_3..., C_n) are connected in parallel. Therefore, the capacitance of the first capacitor C1 in FIG. 10 is a sum of capacitance of the plurality of distributed capacitors (C_1, C_2, C_3..., C_n).

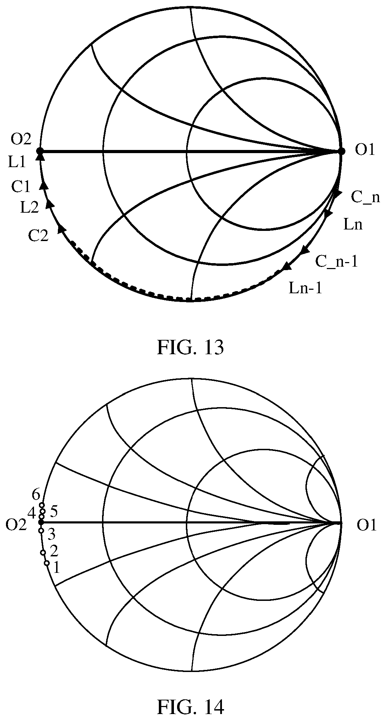

In this case, as shown in FIG. 13, an upper semicircle of the Smith chart is an inductive area, and a lower semicircle is a capacitive area. In addition, a right end point of the horizontal axis of the Smith chart is an open-circuit point O1, and a left end point is a short-circuit point O2. It may be learned from FIG. 11 that the coil Ln located in the outermost circle is not electrically connected to another component. Therefore, the coil Ln and the distributed capacitor C_n are located at the open-circuit point O1 of the Smith chart in FIG. 13. In addition, the contact point in which the copper foil is in contact with the conductive foam is located at the short-circuit point O2 of the Smith chart.

Based on this, as shown in FIG. 13, caused by the plurality of coils (L1, L2, L3, ..., Ln) and the distributed capacitors (C_1, C_2, C_3..., C_n) connected to the coils, impedance of the copper foil moves clockwise, starting from the open-circuit point O1 to the short-circuit point O2. If a size of the copper foil is set properly, the impedance of the copper foil moves to a position near the short-circuit point O2 and stops moving, so that the contact point of the copper foil is in a short-circuit state. In this case, an effect of a capacitive coupling electrical connection of the first capacitor C1 formed by the first component 10 and the copper foil is optimal.

However, if the size of the copper foil is excessively large, a larger quantity of coils and a larger quantity of distributed capacitors are connected in FIG. 12. In this way, the impedance of the copper foil continues to move to the upper semicircle through the short-circuit point O2 in a process of moving clockwise from the open-circuit point O1. Therefore, the first capacitor C1 enters the inductive area. In this case, the first capacitor C1 becomes an inductor, causing the impedance to deviate from the short-circuit point O2. This reduces the effect of the capacitive coupling electrical connection of the first capacitor C1.

According to the foregoing description, in some embodiments of this application, optionally, the area of the second conductive sub-component 302, namely, the copper foil, may be 9 mm$^2$ to 100 mm$^2$ (that is, 3 mm x 3 mm to 10 mm x 10 mm). When the area of the copper foil is less than 3 mm x 3 mm, as shown in FIG. 13, in the process of moving clockwise from the open-circuit point O1, it is difficult for the impedance of the copper foil to reach the short-circuit point O2. When the area of the copper foil is greater than 10 mm x 10 mm, as shown in FIG. 13, in the process of moving clockwise from the open-circuit point O1, a distance between the impedance of the copper foil and the short-circuit point O2 is relatively long, so that the impedance of the copper foil is relatively large.

In some embodiments of this application, optionally, the area of the second conductive sub-component 302, namely, the copper foil, may be 6 mm x 6 mm. When a specification of 6 mm x 6 mm is used for the copper foil in the first capacitor C1 formed by the first component 10 and the copper foil, intermediate and high frequency signals (as shown in Table 1) of different frequencies are selected to test the electrical connection effect of the first capacitor C1.

**Table 1**

| No. | Frequency | Impedance between the first component and the second component |
|---|---|---|
| 1 | 700.00000 MHz | 29 PF |
| 2 | 900.00000 MHz | 29 PF |
| 3 | 1.8000000 GHz | 534 PF |
| 4 | 2.0000000 GHz | 3 PH |
| 5 | 2.4000000 GHz | 11 PH |
| 6 | 2.7000000 GHz | 48 PH |

It may be learned from Table 1 that, when intermediate frequency signals corresponding to a sequence number 1 and a sequence number 2 are used, impedance between the first component 10 and the second component 20 is represented as a capacitance of a capacitor, for example, the capacitance of the first capacitor C1. The capacitance may reach about 30 PF.

When a high frequency signal corresponding to a sequence number 3 is used, the impedance between the first component 10 and the second component 20 is also represented as a capacitance of a capacitor, for example, the capacitance of the first capacitor C1. The capacitance may reach 500 PF.

When high frequency signals corresponding to sequence numbers 4 to 6 are used, the impedance between the first component 10 and the second component 20 is also represented as an inductor. In this case, the first capacitor C1 becomes an inductor, but as shown in FIG. 14, the impedance of the copper foil in the first capacitor C1 moves to a position near the short-circuit point O2. Therefore, the first capacitor C1 still has a good electrical connection effect after being converted into the inductor.

Based on this, the structure shown in FIG. 9a is used as an example. An example in which the electrical connection assembly 01 having the copper foil with the specification of 6 mm x 6 mm is applied to the mobile terminal 02, for example, a mobile phone, to eliminate interference to the antenna 114 is used to describe a process of setting the electrical connection assembly 01 on the mobile terminal 02.

It may be learned from the foregoing description that, to avoid the interference caused by the display screen 1101 to the antenna 114 installed on the middle frame 111, the metal frame 1103 on the back of the display screen 1101 needs to be electrically connected to the conductive surface, for example, an aluminum laser engraving surface, on the middle frame 111, to implement grounding of the metal frame 1103.

In this case, the first component 10 and the second component 20 in the electrical connection assembly 01 are the display module 110 and the middle frame 111 respectively. The conductive surface A1 of the first component 10 is a surface, close to the middle frame 111, of the metal frame 1103 on the back of the display screen 1101. The conductive surface A2 of the second component 20 is the aluminum laser engraving surface formed on the middle frame 111.

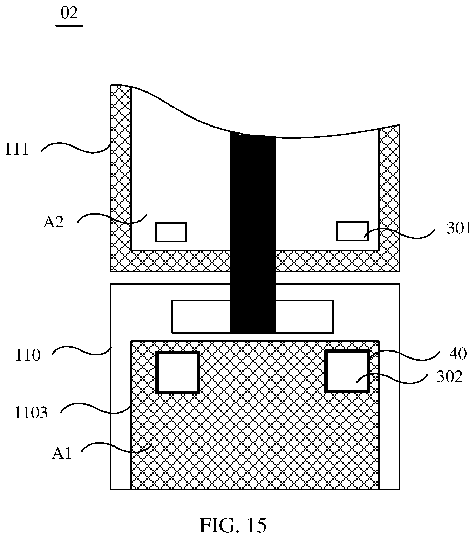

Based on this, because the metal frame 1103 on the back of the display screen 1101 is usually made of stainless steel, a contact resistance of the surface, close to the middle frame 111, of the metal frame 1103 is unstable. Therefore, as shown in FIG. 15, the copper foil (namely, the second conductive sub-component 302) may be attached to the first insulation layer 40. Then, the first insulation layer 40 on which the copper foil is assembled is attached to the surface, close to the middle frame 111, of the metal frame 1103 on the back of the display screen 1101.

Next, because a contact resistance of the aluminum laser engraving surface (namely, the conductive surface A2 of the second component 20) of the middle frame 111 is stable, the conductive foam (namely, the first conductive sub-component 301) may be attached to the aluminum laser engraving surface of the middle frame 111.

Then, the display screen 1101 is installed on the middle frame 111. Because a position of the conductive foam is corresponding to a position of the copper foil, in a process of assembling the display screen 1101 and the middle frame 111, after the conductive foam is pressed, one side, away from the middle frame 111, of the conductive foam is in contact with the copper foil, and the copper foil and the metal frame 1103 on the back of the display screen 1101 form the first capacitor C1, so that the display screen 1101 is electrically connected to the middle frame 111, to implement grounding the metal frame 1103.

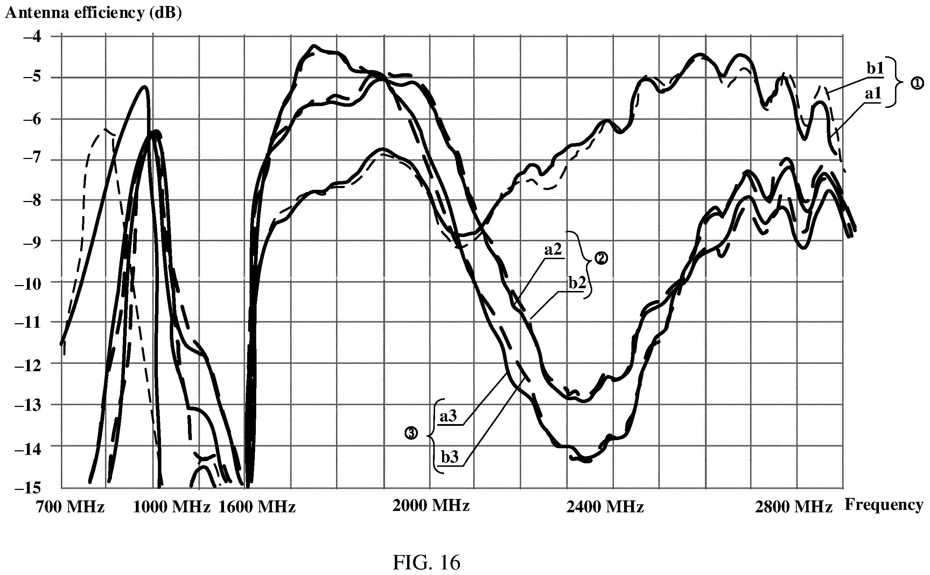

Based on this, an antenna efficiency is tested on the mobile phone that is electrically connected in the capacitive coupling manner. As shown in FIG. 16, three groups (①, ②, and ③) of curves are obtained respectively. Matching parameters of antennas 114 corresponding to different groups are different, so that the antennas 114 corresponding to the different groups may transmit different frequencies.

In any group of curves, a solid line (marked by a1 a2, or a3) represents an electrical connection manner in which the conductive component 30 is directly in contact with the metal frame 1103 on the back of the display screen 1101. A dashed line (marked by b1, b2, or b3) represents an electrical connection manner in which capacitive coupling is formed between the metal frame 1103 on the back of the display screen 1101 and the copper foil. It may be learned from FIG. 16 that, for any group of curves, a curve of the electrical connection manner by using the capacitive coupling basically overlaps a curve obtained in the electrical connection manner of direct contact. Therefore, effects of the two manners are equivalent. This proves that when the copper foil with the foregoing specification is used in the electrical connection assembly 01 in the mobile phone, a good grounding effect can be achieved for the display screen 1101.

Alternatively, the structure shown in FIG. 9a is used as an example. An example in which the electrical connection assembly 01 having the copper foil with the specification of 6 mm x 6 mm is applied to the mobile terminal 02, for example, a mobile phone, to reduce interference of a plurality of chips on the main board to a communication frequency band is used to describe a process of setting the electrical connection assembly 01 on the mobile terminal 02.

It may be learned from the foregoing description that, to avoid mutual interference between the plurality of chips on the main board installed on the middle frame 111, the metal shielding case 113 covered on chips may be electrically connected to a conductive surface, for example, an aluminum laser engraving surface, on the rear housing 112, to implement grounding of the metal shielding case 113. Therefore, the chips covered by the grounded metal shielding case 113 do not cause interference to a chip near the chips.

In this case, the first component 10 and the second component 20 in the electrical connection assembly 01 are the middle frame 111 and the rear housing 112 respectively. The conductive surface A1 of the first component 10 is a surface, close to the rear housing 112, of the metal shielding case 113 on the middle frame 111. The conductive surface A2 of the second component 20 may be the aluminum laser engraving surface formed on the rear housing 112.

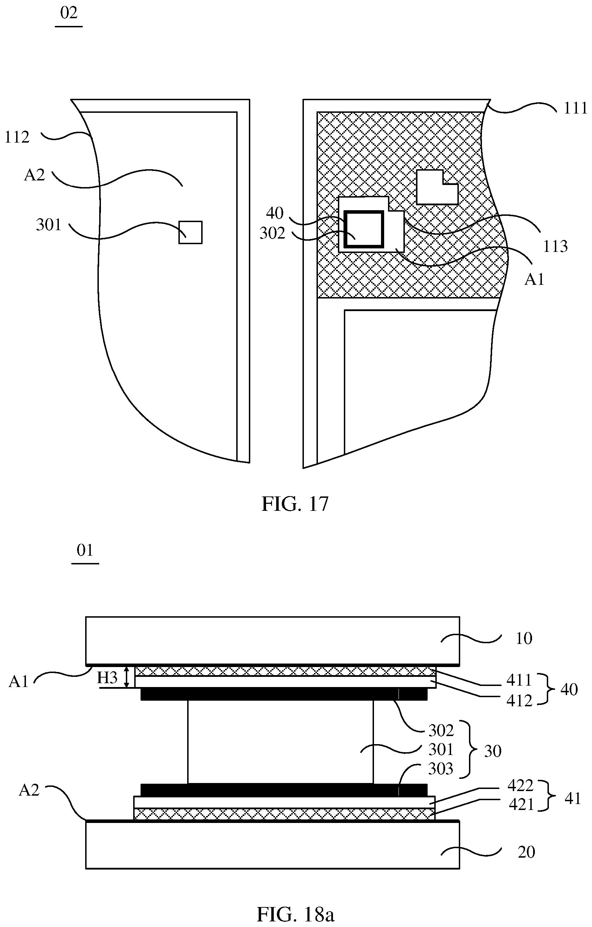

Based on this, because the metal shielding case 113 is usually made of stainless steel, a contact resistance of the surface, close to the rear housing 112, of the metal shielding case 113 is unstable. Therefore, as shown in FIG. 17, the copper foil (namely, the second conductive sub-component 302) may be attached to the first insulation layer 40. Then, the first insulation layer 40 on which the copper foil is assembled is attached to the surface, close to the rear housing 112, of the metal shielding case 113.

Next, because a contact resistance of the aluminum laser engraving surface (namely, the conductive surface A2 of the second component 20) of the rear housing 112 is stable, the conductive foam (namely, the first conductive sub-component 301) may be attached to the aluminum laser engraving surface of the rear housing 112.

Then, the middle frame 111 is installed on the rear housing 112. Because a position of the conductive foam is corresponding to a position of the copper foil, in a process of assembling the middle frame 111 and the rear housing 112, after the conductive foam is pressed, one side, away from the rear housing 112, of the conductive foam is in contact with the copper foil, and the copper foil and the middle frame 111 having the metal shielding case 113 form the first capacitor C1, so that the metal shielding case 113 is electrically connected to the rear housing 112, to implement grounding the metal shielding case 113.

The foregoing descriptions are provided by using the copper foil with the specification of 6 mm x 6 mm as an example. In some other embodiments of this application, a copper foil with another specification may alternatively be selected from the area range of 9 mm$^2$ to 100 mm$^2$ of the copper foil, for example, a copper foil with a specification of 3 mm x 3 mm, 4 mm x 4 mm, 5 mm x 5 mm, 7 mm x 7 mm, or 8 mm x 8 mm. The copper foil may be square or rectangular. This is not limited in this application.

A person skilled in the art may select from the foregoing specifications based on a requirement. For example, it may be learned from the formula (1) that when the thickness H3 of the first insulation layer 40 in the electrical connection assembly 01 is increased, for example, when the thickness of the insulation Mylar 402 in the first insulation layer 40 is increased, to avoid a decrease of the capacitance of the capacitor, a copper foil with a larger size may be selected from the area range of 9 mm$^2$ to 100 mm$^2$ of the copper foil. Example 1 is described by using an example in which the conductive surface A1 of the first component 10 is a conductive surface with unstable contact resistance, and the conductive surface A2 of the second component 20 is a conductive surface with stable contact resistance. When the conductive surface A1 of the first component 10 and the conductive surface A2 of the second component 20 are conductive surfaces with unstable contact resistance, a structure of the conductive component 30 is described in the following example.

Example 2

In this example, as shown in FIG. 18a, an example in which the conductive surface A1 of the first component 10 and the conductive surface A2 of the second component 20 are conductive surfaces with unstable contact resistance, the first insulation layer 40 is disposed on the conductive surface A1 of the first component 10, and the second insulation layer 41 is disposed on the conductive surface A2 of the second component 20 is used for description.

Based on this, as shown in FIG. 18a, the conductive component 30 includes a first conductive sub-component 301, a second conductive sub-component 302, and a third conductive sub-component 303 that are electrically connected.

The first conductive sub-component 301, the second conductive sub-component 302, and the third conductive sub-component 303 each include a first surface and a second surface. The first surface is an upper surface, and the second surface is a lower surface.

In addition, the first surface of the first conductive sub-component 301 is in contact with the second surface of the second conductive sub-component 302. The first surface of the second conductive sub-component 302 is in contact with the first insulation layer 40. The second surface of the first conductive sub-component 301 is in contact with the first surface of the third conductive sub-component 303. The second surface of the third conductive sub-component 303 is in contact with the second insulation layer 41.

In some embodiments of this application, the first conductive sub-component 301 may be conductive foam or a conductive adhesive. The first conductive sub-component 301 conducts electricity, and may further be configured to support the first component 10 and the second component 20 that are located on two sides of the first conductive sub-component 301.

The second conductive sub-component 302 and the third conductive sub-component 303 are metal sheets or conductive films. The metal sheets may be copper foils, and the conductive films may be conductive fabrics.

For ease of description, the following embodiments are described based on the first conductive sub-component 301 being the conductive foam, and the second conductive sub-component 302 and the third conductive sub-component 303 being the copper foils.

Based on this, as shown in FIG. 18a, a manner of disposing the first conductive sub-component 301, the second conductive sub-component 302, and the third conductive sub-component 303 of the conductive component 30 may be that a contact surface between the first surface of the first conductive sub-component 301 and the second surface of the second conductive sub-component 302 is located within an edge of the second surface of the second conductive sub-component 302. In this case, the copper foil used as the second conductive sub-component 302 is tiled on a surface, close to the second conductive sub-component 302, of the first insulation layer 40. In a manufacturing process, the second conductive sub-component 302 and the first insulation layer 40 may be packaged together and assembled on the first component 10.

In addition, a contact surface between the second surface of the first conductive sub-component 301 and the first surface of the third conductive sub-component 303 is located within an edge of the first surface of the third conductive sub-component 303. In this case, the copper foil used as the third conductive sub-component 303 is tiled on a surface, close to the second conductive sub-component 302, of the second insulation layer 41. In the manufacturing process, the third conductive sub-component 303 and the second insulation layer 41 may be packaged together and assembled on the second component 20. The first conductive sub-component 301 may be attached to the first surface of the third conductive sub-component 303 in an adhesive bonding manner.

Then, the first component 10 and the second component 20 are installed together, so that the first surface of the first conductive sub-component 301 is in contact with the second surface of the second conductive sub-component 302.

Same as Example 1, an area of the second surface of the second conductive sub-component 302 is 9 mm$^2$ to 100 mm$^2$. An area of the first surface of the third conductive sub-component 303 is 9 mm$^2$ to 100 mm$^2$.

In addition, as shown in FIG. 18a, the first insulation layer 40 includes a first insulation adhesive 411 and a first insulation Mylar 412. The first insulation adhesive 411 is in contact with the conductive surface A1 of the first component 10. The first insulation Mylar 412 is in contact with the conductive component 30. When the conductive component 30 includes the first conductive sub-component 301, the second conductive sub-component 302, and the third conductive sub-component 303, the first insulation Mylar 412 is in contact with the first surface of the second conductive sub-component 302.

The second insulation layer 41 includes a second insulation adhesive 421 and a second insulation Mylar 422. The second insulation adhesive 421 is in contact with the conductive surface A2 of the second component 20. The second insulation Mylar 422 is in contact with the conductive component 30. When the conductive component 30 includes the first conductive sub-component 301, the second conductive sub-component 302, and the third conductive sub-component 303, the second insulation Mylar 422 is in contact with the second surface of the third conductive sub-component 303.

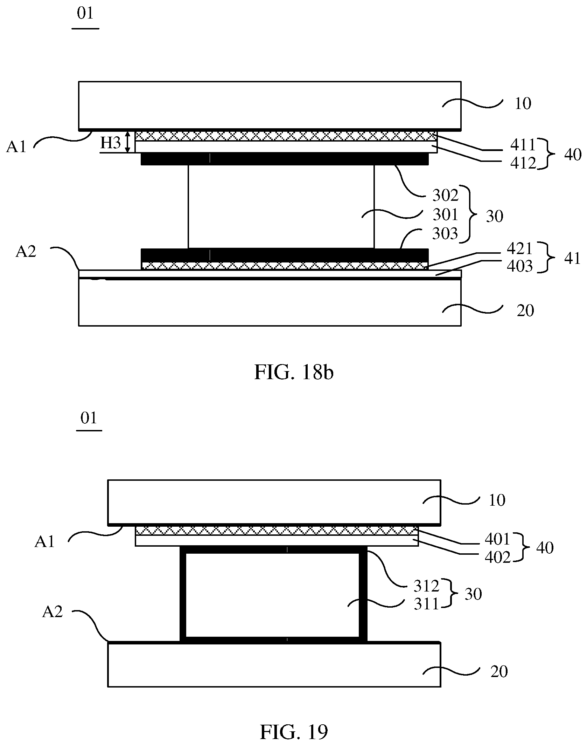

Alternatively, when the conductive surface A2 of the second component 20 is processed by using a process such as anodizing to form the insulation film 403, the second insulation Mylar 422 may not be disposed. In this case, as shown in FIG. 18b, the second insulation layer 41 includes the insulation film 403 and the second insulation adhesive 421. The insulation film 403 covers the conductive surface A2 of the second component 20. The second insulation adhesive 421 is located between the insulation film 403 and the conductive component 30, and the second insulation adhesive 421 is in contact with the insulation film 403 and the conductive component 30. When the structure of the conductive component 30 is shown in FIG. 18b, the second insulation adhesive 421 is in contact with the third conductive sub-component 303 of the conductive component 30. In addition, a disposing manner of the first insulation layer 40 in FIG. 18b is the same as that described above, and details are not described herein again.

It should be noted that a manner of manufacturing the insulation film 403 may be: an oxidized layer formed by using the anodizing process is used as the insulation film 403. Alternatively, a film layer formed by spraying or coating an insulating resin material may be used as the insulation film 403.

The foregoing description is provided by using an example in which the insulation film 403 is formed on the conductive surface A2 of the second component 20. When the conductive surface A1 of the first component 10 also forms the insulating insulation film 403 by using the anodizing process, a disposing manner of the first insulation layer 41 is the same as that described above, and details are not described herein again.

In addition, a thickness range of the second insulation layer 41 may be 0.01 mm to 0.05 mm. A technical effect of the thickness setting range of the second insulation layer 41 is the same as a technical effect of the thickness setting range of the first insulation layer 40, and details are not described herein again.

In this case, copper foils (namely, the second conductive sub-component 302 and the third conductive sub-component 303) are disposed on both sides of the conductive foam (the first conductive sub-component 301), so that the copper foil (namely, the second conductive sub-component 302) located above and the first component 10 form a first capacitor C1 shown in FIG. 6, and the copper foil (namely, the third conductive sub-component 303) located below and the second component 20 form the second capacitor C2 shown in FIG. 6. In this case, a signal of the first component 10 is coupled to the copper foil located above by using the first capacitor C1, and the copper foil transmits the signal to the copper foil located below by using the conductive foam. The copper foil located below couples the signal to the second component 20 by using the second capacitor C2.

When the electrical connection assembly 01 shown in FIG. 18a is used as an example to describe grounding processing of some components in the mobile phone, conductive surfaces of the first component 10 and the second component 20 on both sides of the conductive component 30 are surfaces with unstable contact resistance. In this case, in FIG. 15, the middle frame 111 used as the second component 20 is made of stainless steel, and the aluminum laser engraving surface is not disposed on a surface, close to the display screen 1101, of the middle frame 111. In this case, a copper foil (namely, the third conductive sub-component 303) is attached to the second insulation layer 41, and then the second insulation layer 41 assembled with the copper foil is attached to the surface, close to the display screen 1101, of the middle frame 111. In addition, in the display module 110 used as the first component 10, the first insulation layer 40 and another copper foil (namely, the second conductive sub-component 302) are still sequentially attached to a surface, close to the middle frame 111, of the metal frame 1103 on the back of the display screen 1101. In this way, capacitors used to implement a coupled electrical connection are disposed on both sides of the conductive foam.

It may be learned from the solution in Example 1 or Example 2 that, before the first component 10 and the second component 20 are assembled, the conductive foam used as the first conductive sub-component 301 and the copper foil used as the second conductive sub-component 302 in the conductive component 30 are respectively located on the first component 10 and the second component 20. In this case, to improve conductive performance of the conductive component 30 in a process of assembling the first component 10 and the second component 20, the conductive foam needs to be in close contact with the copper foil. In this way, in an installation process, it is necessary to apply relatively large press pressure to the conductive foam. However, some components that need grounding are sensitive to the press pressure, for example, the display screen 1101 installed with the metal frame 1103, or a camera. The relatively large press pressure affects quality of the components.

To resolve the problem, some embodiments of this application provide another disposing manner of the conductive component 30.

Example 3

In this example, as shown in FIG. 19, FIG. 20, FIG. 21a, and FIG. 21b, the conductive component 30 includes a support part 311 and a conductive body 312. At least three surfaces of the support part 311 are covered with the conductive body 312.

In some embodiments of this application, the support part 311 may be conductive foam. The support part 311 may support the first component 10 and the second component 20. In addition, the conductive body 312 may be a metal sheet or a conductive film. For ease of description, the following uses an example in which the conductive body 312 is a copper foil for description.

The at least three surfaces of the support part 311 include a surface close to the first component 10 and a surface close to the second component 20.

A manner in which the at least three surfaces of the support part 311 (namely, the foam) are covered with the conductive body 312 (namely, the copper foil) is as follows:

For example, as shown in FIG. 19, the copper foil is in contact with four surfaces of the foam: an upper surface (namely, a surface close to the first component 10), a lower surface (namely, a surface close to the second component 20), a left surface, and a right surface. In this case, the copper foil may be wound around the foam for one circle, and the foam is wrapped.

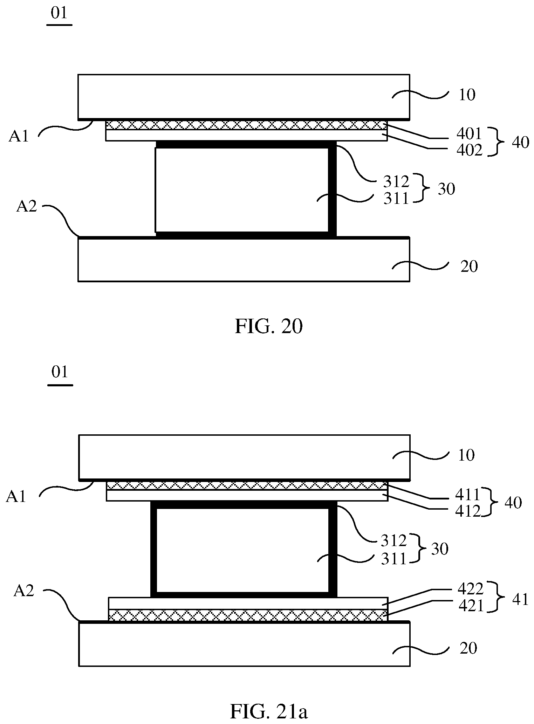

Alternatively, for another example, as shown in FIG. 20, the copper foil is in contact with the upper surface, the lower surface, and the right surface of the foam. In this case, the copper foil wraps the upper surface, the lower surface, and the right surface of the conductive foam.

It may be learned from FIG. 19 and FIG. 20 that, in the electrical connection assembly 01, the first insulation layer 40 is disposed on a surface, close to the conductive component 30, of the first component 10, and a surface of the second component 20 is in contact with the conductive component 30. It may be learned from the foregoing description that in the solutions shown in FIG. 19 and FIG. 20, a contact resistance of the conductive surface A1 of the first component 10 is unstable, and a contact resistance of the conductive surface A2 of the second component 20 is stable.

The first insulation layer 40 may include the insulation adhesive 401 in contact with the conductive surface A1 of the first component 10, and the insulation Mylar 402 in contact with the conductive body 312 (namely, the copper foil).

In addition, when the contact resistances of the conductive surface A1 of the first component 10 and the conductive surface A2 of the second component 20 are unstable, a solution shown in FIG. 21a may be used. In the solution shown in FIG. 21a, the first insulation layer 40 includes the first insulation adhesive 411 and the first insulation Mylar 412. A disposing manner of the first insulation adhesive 411 and the first insulation Mylar 412 is the same as that described above, and details are not described herein again.

In the solution shown in FIG. 21a, the second insulation layer 41 is disposed between the conductive component 30 and the conductive surface A2 of the second component 20. The second insulation layer 41 includes the second insulation adhesive 421 and the second insulation Mylar 422. A disposing manner of the second insulation adhesive 421 and the second insulation Mylar 422 is the same as that described above, and details are not described herein again.

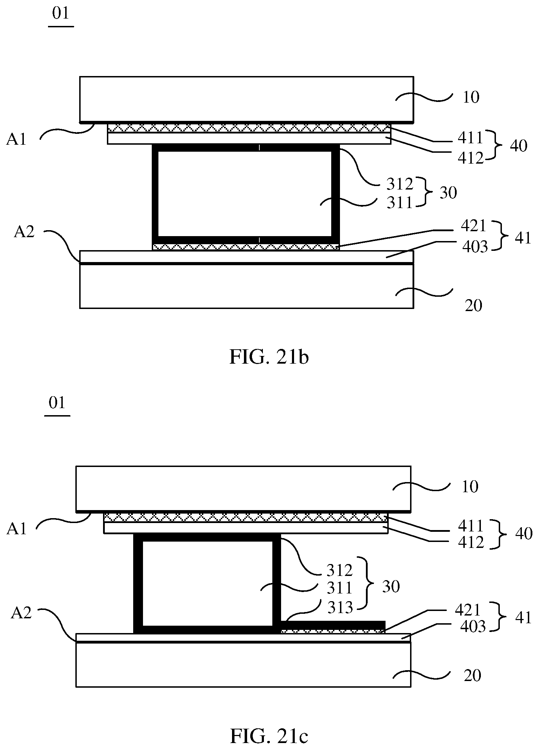

Alternatively, when the contact resistances of the conductive surface A1 of the first component 10 and the conductive surface A2 of the second component 20 are unstable, a solution shown in FIG. 21b may be used. To be specific, when the conductive surface A2 of the second component 20 is processed by using a process such as anodizing to form the insulation film 403, the second insulation Mylar 422 may not be disposed.

In this case, as shown in FIG. 21b, the second insulation layer 41 includes the insulation film 403 and the second insulation adhesive 421. The insulation film 403 covers the conductive surface A2 of the second component 20. The second insulation adhesive 421 is located between the insulation film 403 and the conductive component 30, and in contact with the insulation film 403 and the conductive component 30. When the structure of the conductive component 30 is shown in FIG. 21b, the second insulation adhesive 421 is in contact with the conductive body 312 of the conductive component 30.

In addition, when the second insulation layer 41 includes the insulation film 403 and the second insulation adhesive 421, if the contact resistances of the conductive surface A1 of the first component 10 and the conductive surface A2 of the second component 20 are unstable, a solution shown in FIG. 21c may alternatively be used. To be specific, the conductive component 30 further includes a conductive extension part 313 connected to the conductive body 312.

A vertical projection of the conductive body 312 on the second component 20 does not overlap a vertical projection of the conductive extension part 313 on the second component 20. In this case, the conductive extension part 313 extends out of an area in which the conductive body 312 is located.

Optionally, the conductive extension part 313 and the conductive body 312 may be an integrated structure. For example, a part of a copper foil is the conductive body 312 used to cover the support part 311, and another part of the copper foil is the conductive extension part 313.

In this case, to enable the insulation film 403 to be in contact with the conductive component 30, as shown in FIG. 21c, in the conductive component 30, at least the conductive extension part 313 is in contact with the second insulation adhesive 421.

In this way, compared with the solution shown in FIG. 21b, in the solution shown in FIG. 21c, based on an appropriate reduction of a volume of the support part 311 (namely, the foam), the conductive extension part 313 being disposed in the conductive component 30 may increase an area of an upper plate of a second capacitor C formed by the conductive component 30 and the second component 20. This improves an effect of coupled feeding.

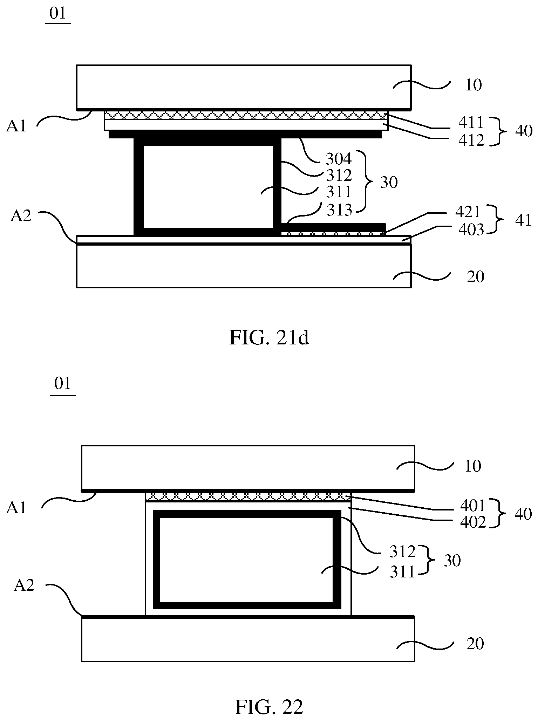

Based on this, when the volume of the support part 311 (namely, the foam) is reduced, to avoid reducing a capacitance of the second capacitor C, optionally, as shown in FIG. 21d, the conductive component 30 further includes a fourth conductive sub-component 304. The fourth conductive sub-component 304 includes a first surface and a second surface. As described above, the first surface is an upper surface, and the second surface is a lower surface.

In this case, the first surface of the fourth conductive sub-component 304 is in contact with the first insulation Mylar 412. The second surface of the fourth conductive sub-component 304 is in contact with the conductive body 312. In this case, the fourth conductive sub-component 304 may be a copper foil. An area of a lower surface of the copper foil may be greater than an area of an upper surface of the foam. A setting manner of the area of the lower surface of the fourth conductive sub-component 304 is the same as that described above. For example, the area is 9 mm$^2$ to 100 mm$^2$. In this way, when the volume of the support part 311 (namely, the foam) is reduced, the capacitance of the second capacitor C formed by the conductive component 30 and the second component 20 may not be reduced.

In addition, when the conductive component 30 includes the support part 311 and the conductive body 312, and the first insulation layer 40 includes the insulation adhesive 401 and the insulation Mylar 402, some embodiments of this application provide another disposing manner of the conductive component 30.

Example 4

As shown in FIG. 22, FIG. 23, and FIG. 24, in this example, the at least three surfaces of the support part 311 are sequentially covered with the conductive body 312 and the insulation Mylar 402.

The at least three surfaces of the support part 311 include a surface close to the first component 10 and a surface close to the second component 20.

A manner in which the at least three surfaces of the support part 311 (namely, the foam) are sequentially covered with the conductive body 312 (namely, the copper foil) and the insulation Mylar 402 is as follows: For example, as shown in FIG. 22, the upper surface (namely, the surface close to the first component 10), the lower surface (namely, the surface close to the second component 20), the left surface, and the right surface of the support part 311 (namely, the foam) are sequentially covered with the conductive body 312 (namely, the copper foil) and the insulation Mylar 402. In this case, the copper foil and the insulation Mylar 402 may be sequentially wound around the foam for one circle, and the foam is wrapped.

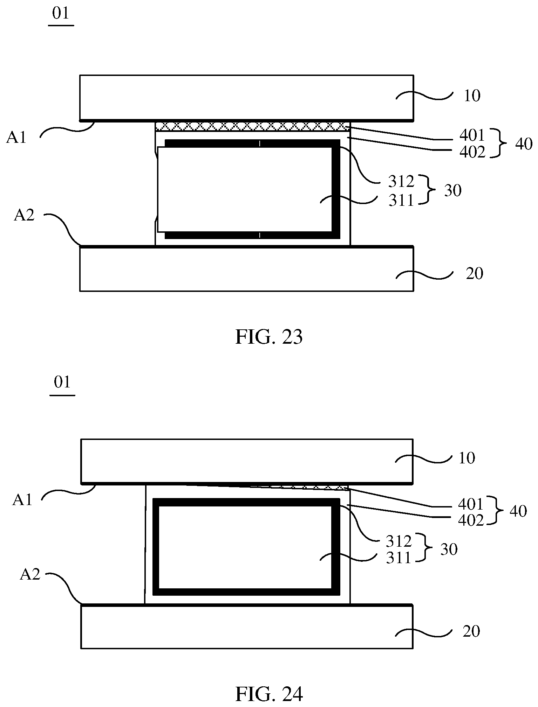

Alternatively, as shown in FIG. 23, the upper surface, the lower surface, and the right surface of the support part 311 (namely, the foam) are sequentially covered with the conductive body 312 (namely, the copper foil) and the insulation Mylar 402.

It should be noted that, when the solution shown in FIG. 22 or FIG. 23 is used, the insulation adhesive 401 at the first insulation layer 40 is used to fasten the foam covering the insulation Mylar 402 and the copper foil on the conductive surface A1 of the first component 10. Therefore, the insulation adhesive 401 does not need to completely cover the conductive surface A1 of the first component 10. To be specific, the solution shown in FIG. 24 may be used. A few insulation adhesives 401 are disposed between the insulation Mylar 402 and the conductive surface A1 of the first component 10 to achieve fastening.

In conclusion, in the foregoing solutions, the at least three surfaces of the support part 311 (namely, the foam) are covered with the conductive body 312 (namely, the copper foil). Therefore, before the first component 10 and the second component 20 are assembled, the copper foil may be in close contact with the foam. In this case, when the first component 10 and the second component 20 are assembled, it is not necessary to apply relatively large pressure to the foam. Therefore, the foregoing solutions are applicable to a relatively pressure-sensitive component, for example, the display screen 1101 installed with the metal frame 1103, or a camera (Camera).

For example, the electrical connection assembly 01 shown in FIG. 24 is used as an example to describe grounding of the display screen 1101 installed with the metal frame 1103.

The first component 10 and the second component 20 in the electrical connection assembly 01 are the display module 110 and the middle frame 111 respectively. In this case, the foam covered with the insulation Mylar 402 and the copper foil is fastened, by using the insulation adhesive 401, to a side, away from the middle frame 111, of the metal frame 1103 of the display screen 1101. Then, the display screen 1101 is assembled with the middle frame 111. In this way, a conductive surface on the middle frame 111 is in contact with a side, away from the display module 110, of the foam wrapped with the insulation Mylar 402 and the copper foil.

For another example, the electrical connection assembly 01 shown in FIG. 24 is used as an example to describe grounding of the camera.

The first component 10 and the second component 20 in the electrical connection assembly 01 are the camera and the middle frame 111 respectively. In this case, the foam covered with the insulation Mylar 402 and the copper foil is fastened to a ground end of the camera by using the insulation adhesive 401. Then, the camera is installed on the middle frame 111. In this way, the conductive surface on the middle frame 111 is in contact with a side, away from the camera, of the foam covered with the insulation Mylar 402 and the copper foil.

In the solutions shown in FIG. 19 to FIG. 24, the copper foil covers the at least three surfaces of the foam. It may be learned from a principle of setting a size of the planar electrode in the foregoing capacitor that the foam covered with the insulation Mylar 402 and the copper foil, or the foam including only the copper foil may be used as a planar electrode of a capacitor used for a capacitive coupling electrical connection. Therefore, an area of the surface, close to the first component 10 or the second component 20, of the support part 311 (namely, the foam) is 9 mm$^2$ to 100 mm$^2$.

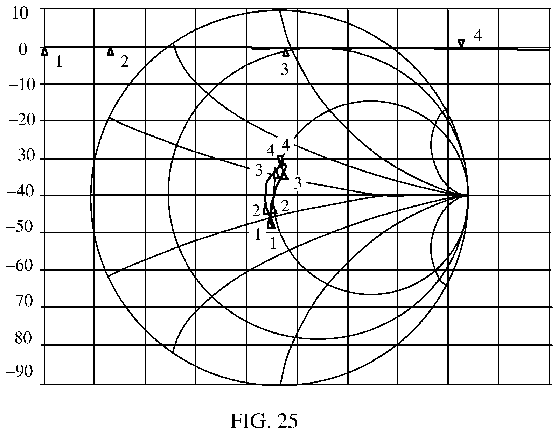

For example, an area of the foam is 36 mm$^2$ (a specification is 6 mm x 6 mm), and the solutions shown in FIG. 19 to FIG. 24 are used. Intermediate and high frequency signals (as shown in Table 2) at different frequencies are selected to test a conduction effect of the first component 10 and the second component 20. Test results are shown in FIG. 25.

**Table 2**

| No. | Frequency | Loss |
|---|---|---|
| 1 | 700.00000 MHz | 0.2022 dB |
| 2 | 1.0000000 GHz | 0.1551 dB |

(continued)

| No. | Frequency | Loss |
|---|---|---|
| 3 | 1.8000000 GHz | 0.3697 dB |
| 4 | 2.6000000 GHz | 0.6878 dB |

It may be learned from FIG. 25 that, when the conduction effect of the first component 10 and the second component 20 is tested by using frequencies corresponding to sequence numbers in Table 2, test results corresponding to the sequence numbers (1, 2, 3, and 4) are all located near the center of a Smith chart, and a horizontal coordinate (indicating a loss) corresponding to each test result is near a horizontal coordinate 0. In this case, a loss in a conduction process of the first component 10 and the second component 20 is close to zero. Therefore, the foregoing electrical connection assembly 01 may have a good signal transmission effect.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

**Claims**

1. A mobile terminal (02), comprising an electrical connection assembly (01);

   wherein the electrical connection assembly (01) comprises a first component (10), a second component (20), an electrically conductive component (30), and a first insulation layer (40), wherein the first component (10) and the second component (20) are installed together in a detachable connection manner, wherein the detachable connection manner is a threaded connection manner, a buckle connection manner, or bonded together by using an adhesive layer, and wherein one of the first component (10) and the second component (20) forms an outer surface of the mobile terminal;
   the first component (10) and the second component (20) each have a conductive surface (A1 or A2), and the conductive surface (A1) of the first component (10) is disposed opposite to the conductive surface (A2) of the second component (20);
   wherein the conductive surface (A1) of the first component (10) is a surface of the first component (10) close to the electrically conductive component (30), the conductive surface (A2) of the second component (20) is a surface of the second component (20) close to the electrically conductive component (30);
   the electrically conductive component (30) is located between the first component (10) and the second component (20),
   wherein the first insulation layer (40) is disposed on the conductive surface (A1) of the first component (10), and the electrically conductive component (30) is in contact with the first insulation layer (40);
   wherein the electrically conductive component (30), the first insulation layer (40) and the first component (10) form a first capacitor; and
   the electrically conductive component (30) is electrically connected to the conductive surface (A2) of the second component (20).

2. The mobile terminal (02) according to claim 1, wherein the material of the conductive surface (A1) of the first component (10) includes stainless steel or metal aluminum.

3. The mobile terminal (02) according to claim 1, wherein the electrically conductive component (30) is in contact with the conductive surface (A2) of the second component (20).

4. The mobile terminal (02) according to claim 1, wherein the electrically conductive component comprises a first conductive sub-component (301) and a second conductive sub-component (302) that are electrically connected;

   the first conductive sub-component (301) and the second conductive sub-component (302) each comprise a first surface and a second surface;
   the first surface of the first conductive sub-component (301) is in contact with the second surface of the second conductive sub-component (302);
   the first surface of the second conductive sub-component (302) is in contact with the first insulation layer; and

the second surface of the first conductive sub-component (301) is in contact with the conductive surface of the second component (20).

5. The mobile terminal (02) according to claim 4, wherein an area of the second surface of the second conductive sub-component (302) is 9 mm$^2$ to 100 mm$^2$.

6. The mobile terminal (02) according to claim 1, wherein a thickness of the first insulation layer (40) is 0.01 mm to 0.05 mm.

7. The mobile terminal (02) according to claim 1, wherein the first insulation layer (40) includes an insulation adhesive (401).

8. The mobile terminal (02) according to claim 1, wherein the first insulation layer (40) includes an insulation film (403), wherein the insulation film (403) is formed by using a anodizing.

9. The mobile terminal (02) according to claim 1, wherein the conductive surface (A2) of the second component (20) is an aluminum laser engraving surface formed on the middle frame (111).

10. The mobile terminal (02) according to claim 1, wherein the first component (10) is a display module (110) and the second component (20) is a middle frame (111).


**Patentansprüche**

1. Mobiles Endgerät (02), das eine elektrische Verbindungsanordnung (01) umfasst;

wobei die elektrische Verbindungsanordnung (01) eine erste Komponente (10), eine zweite Komponente (20), eine elektrisch leitfähige Komponente (30) und eine erste Isolierschicht (40) umfasst, wobei die erste Komponente (10) und die zweite Komponente (20) in einer lösbaren Verbindungsart zusammen installiert sind, wobei die lösbare Verbindungsart eine Schraubverbindungsart, eine Schnallenverbindung oder durch Verwenden einer Klebeschicht zusammengeklebt ist, und wobei eine der ersten Komponente (10) und der zweiten Komponente (20) eine Außenoberfläche des mobilen Endgeräts ausbildet;
wobei die erste Komponente (10) und die zweite Komponente (20) jeweils eine leitfähige Oberfläche (A1 oder A2) aufweisen und die leitfähige Oberfläche (A1) der ersten Komponente (10) gegenüber der leitfähigen Oberfläche (A2) der zweiten Komponente (20) angeordnet ist;
wobei die leitfähige Oberfläche (A1) der ersten Komponente (10) eine Oberfläche der ersten Komponente (10) nahe der elektrisch leitfähigen Komponente (30) ist, die leitfähige Oberfläche (A2) der zweiten Komponente (20) eine Oberfläche der zweiten Komponente (20) nahe der elektrisch leitfähigen Komponente (30) ist;
wobei die elektrisch leitfähige Komponente (30) sich zwischen der ersten Komponente (10) und der zweiten Komponente (20) befindet,
wobei die erste Isolierschicht (40) auf der leitfähigen Oberfläche (A1) der ersten Komponente (10) angeordnet ist und die elektrisch leitfähige Komponente (30) in Kontakt mit der ersten Isolierschicht (40) steht;
wobei die elektrisch leitfähige Komponente (30), die erste Isolierschicht (40) und die erste Komponente (10) einen ersten Kondensator ausbilden; und
die elektrisch leitfähige Komponente (30) mit der leitfähigen Oberfläche (A2) der zweiten Komponente (20) elektrisch verbunden ist.

2. Mobiles Endgerät (02) nach Anspruch 1, wobei das Material der leitfähigen Oberfläche (A1) der ersten Komponente (10) Edelstahl oder Metallaluminium einschließt.

3. Mobiles Endgerät (02) nach Anspruch 1, wobei die elektrisch leitfähige Komponente (30) mit der leitfähigen Oberfläche (A2) der zweiten Komponente (20) in Kontakt steht.

4. Mobiles Endgerät (02) nach Anspruch 1, wobei die elektrisch leitfähige Komponente eine erste leitfähige Unterkomponente (301) und eine zweite leitfähige Unterkomponente (302) umfasst, die elektrisch verbunden sind;

wobei die erste leitfähige Unterkomponente (301) und die zweite leitfähige Unterkomponente (302) jeweils eine erste Oberfläche und eine zweite Oberfläche umfassen;

wobei die erste Oberfläche der ersten leitfähigen Unterkomponente (301) mit der zweiten Oberfläche der zweiten leitfähigen Unterkomponente (302) in Kontakt steht; wobei die erste Oberfläche der zweiten leitfähigen Unterkomponente (302) mit der ersten Isolierschicht in Kontakt steht; und

wobei die zweite Oberfläche der ersten leitfähigen Unterkomponente (301) mit der leitfähigen Oberfläche der zweiten Komponente (20) in Kontakt steht.

5. Mobiles Endgerät (02) nach Anspruch 4, wobei eine Fläche der zweiten Oberfläche der zweiten leitfähigen Unterkomponente (302) 9 mm$^2$ bis 100 mm$^2$ beträgt.

6. Mobiles Endgerät (02) nach Anspruch 1, wobei eine Dicke der ersten Isolierschicht (40) 0,01 mm bis 0,05 mm beträgt.

7. Mobiles Endgerät (02) nach Anspruch 1, wobei die erste Isolierschicht (40) einen Isolierklebstoff (401) einschließt.

8. Mobiles Endgerät (02) nach Anspruch 1, wobei die erste Isolierschicht (40) einen Isolierfilm (403) einschließt, wobei der Isolierfilm (403) durch Verwenden einer Anodisierung ausgebildet wird.

9. Mobiles Endgerät (02) nach Anspruch 1, wobei die leitfähige Oberfläche (A2) der zweiten Komponente (20) eine auf dem Mittelrahmen (111) ausgebildete Aluminium-Lasergravuroberfläche ist.

10. Mobiles Endgerät (02) nach Anspruch 1, wobei die erste Komponente (10) ein Anzeigemodul (110) ist und die zweite Komponente (20) ein Mittelrahmen (111) ist.

**Revendications**

1. Terminal mobile (02), comprenant un ensemble de connexion électrique (01) ;

dans lequel l'ensemble de connexion électrique (01) comprend un premier composant (10), un second composant (20), un composant électriquement conducteur (30), et une première couche d'isolation (40), dans lequel le premier composant (10) et le second composant (20) sont installés ensemble selon une manière de connexion amovible, dans lequel la manière de connexion amovible est une manière de connexion filetée, une manière de connexion à boucle, ou collés ensemble à l'aide d'une couche adhésive, et dans lequel l'un parmi le premier composant (10) et le second composant (20) forme une surface extérieure du terminal mobile ;

le premier composant (10) et le second composant (20) ont chacun une surface conductrice (A1 ou A2), et la surface conductrice (A1) du premier composant (10) est disposée à l'opposé de la surface conductrice (A2) du second composant (20) ; dans lequel la surface conductrice (A1) du premier composant (10) est une surface du premier composant (10) proche du composant électriquement conducteur (30), la surface conductrice (A2) du second composant (20) est une surface du second composant (20) proche du composant électriquement conducteur (30) ;

le composant électriquement conducteur (30) est situé entre le premier composant (10) et le second composant (20),

dans lequel la première couche d'isolation (40) est disposée sur la surface conductrice (A1) du premier composant (10), et le composant électriquement conducteur (30) est en contact avec la première couche d'isolation (40) ;

dans lequel le composant électriquement conducteur (30), la première couche d'isolation (40) et le premier composant (10) forment un premier condensateur ; et

le composant électriquement conducteur (30) est électriquement connecté à la surface conductrice (A2) du second composant (20).

2. Terminal mobile (02) selon la revendication 1, dans lequel le matériau de la surface conductrice (A1) du premier composant (10) comporte de l'acier inoxydable ou de l'aluminium métallique.

3. Terminal mobile (02) selon la revendication 1, dans lequel le composant électriquement conducteur (30) est en contact avec la surface conductrice (A2) du second composant (20).

4. Terminal mobile (02) selon la revendication 1, dans lequel le composant électriquement conducteur comprend un premier sous-composant conducteur (301) et un second sous-composant conducteur (302) qui sont électriquement connectés ;

le premier sous-composant conducteur (301) et le second sous-composant conducteur (302) comprennent chacun une première surface et une seconde surface ;

la première surface du premier sous-composant conducteur (301) est en contact avec la seconde surface du second sous-composant conducteur (302) ;

la première surface du second sous-composant conducteur (302) est en contact avec la première couche d'isolation ; et

la seconde surface du premier sous-composant conducteur (301) est en contact avec la surface conductrice du second composant (20).

5. Terminal mobile (02) selon la revendication 4, dans lequel une zone de la seconde surface du second sous-composant conducteur (302) va de 9 mm$^2$ à 100 mm$^2$.

6. Terminal mobile (02) selon la revendication 1, dans lequel une épaisseur de la première couche d'isolation (40) va de 0,01 mm à 0,05 mm.

7. Terminal mobile (02) selon la revendication 1, dans lequel la première couche d'isolation (40) comporte un adhésif d'isolation (401).

8. Terminal mobile (02) selon la revendication 1, dans lequel la première couche d'isolation (40) comporte un film d'isolation (403), dans lequel le film d'isolation (403) est formé en utilisant une anodisation.

9. Terminal mobile (02) selon la revendication 1, dans lequel la surface conductrice (A2) du second composant (20) est une surface de gravure laser en aluminium formée sur le cadre central (111).

10. Terminal mobile (02) selon la revendication 1, dans lequel le premier composant (10) est un module d'affichage (110) et le second composant (20) est un cadre central (111).

01

FIG. 1

02

FIG. 2

02

FIG. 3

FIG. 4

<u>01</u>

FIG. 5

FIG. 6

FIG. 7

FIG. 8

FIG. 9a

FIG. 9b

10

C1

R1

R2

20

FIG. 10

302

Ln

Contact point

L1

FIG. 11

L1    L2    L3    L4

Contact point

C_1    C_2    C_3    C_n

FIG. 12

FIG. 13

FIG. 14

02

111

A2

301

110

40

302

1103

A1

FIG. 15

FIG. 16

02

112

A2

301

111

40
302

113

A1

FIG. 17

01

10

A1    H3

411
412    } 40

302
301    } 30
303

422
421    } 41

A2

20

FIG. 18a

01

A1    H3

10

411 }
412 } 40

302
301 } 30
303

A2

421 }
403 } 41

20

**FIG. 18b**

01

10

A1

401 }
402 } 40

312 }
311 } 30

A2

20

**FIG. 19**

01

FIG. 20

01

FIG. 21a

01

FIG. 21b

01

FIG. 21c

01

FIG. 21d

01

FIG. 22

01

FIG. 23

01

FIG. 24

FIG. 25

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2010020456 A1
- US 2007230156 A1
- WO 2017204585 A1
- US 2015109170 A1
- US 6011690 A